# EUROPEAN PATENT APPLICATION

(11) **EP 4 766 064 A1**
(43) Date of publication of application: **24.06.2026**
(21) Application number: 25219136.6
(22) Date of filing: 27.11.2025
(51) Int. Cl.: H10B 12/00

(54) **SEMICONDUCTOR DEVICES**

(30) Priority: 18.12.2024 KR 20240189506
(71) Applicant: Samsung Electronics Co., Ltd., Suwon-si, Gyeonggi-do 16677 (KR)
(72) Inventor: KIM, Seokwon, 16677 Suwon-si (KR); LEE, Sunjung, 16677 Suwon-si (KR); LEE, Jungha, 16677 Suwon-si (KR); LEE, Dosun, 16677 Suwon-si (KR)
(74) Representative: Marks & Clerk LLP

(57) **Abstract**

A semiconductor device includes a channel disposed on a substrate and extending in a first direction; a gate structure extending in a second direction, wherein the gate structure surrounds at least a portion of a first end portion in the first direction of the channel; a bit line electrically connected to the channel and extending in a vertical direction along a sidewall in the first direction of the first end portion of the channel; and a capacitor disposed at a sidewall in the first direction of a second end portion of the channel, the second end portion of the channel being an end portion in the first direction of the channel facing the first end portion of the channel, wherein the sidewall in the first direction of the second end portion of the channel includes an upper and a lower sidewalls, and the upper sidewall and the lower sidewall converge to form a V-shaped configuration, with a vertex formed by the upper and the lower sidewalls being oriented toward an interior of the channel.

## Description

### TECHNICAL FIELD

Example embodiments of the inventive concept relate to a semiconductor device. More particularly, example embodiments of the inventive concept relate to a three-dimensional (3D) memory device.

### DISCUSSION OF RELATED ART

A DRAM device includes word lines, bit lines, channels and capacitors. In order to increase the integration degree of the DRAM device, the word lines, the bit lines, the channels and the capacitors are needed to be efficiently arranged.

### SUMMARY

Example embodiments of the inventive concept provide a semiconductor device having enhanced electrical characteristics.

According to example embodiments of the inventive concept, there is provided a semiconductor device. The semiconductor device may include a channel disposed on a substrate and extending in a first direction substantially parallel to an upper surface of the substrate; a gate structure extending in a second direction substantially parallel to the upper surface of the substrate and crossing the first direction, wherein the gate structure surrounds at least a portion of a first end portion in the first direction of the channel; a bit line electrically connected to the channel and extending in a vertical direction substantially perpendicular to the upper surface of the substrate along a sidewall in the first direction of the first end portion of the channel; and a capacitor disposed at a sidewall in the first direction of a second end portion of the channel, the second end portion of the channel being an end portion in the first direction of the channel facing (e.g., opposite to) the first end portion of the channel, wherein the sidewall in the first direction of the second end portion of the channel includes an upper sidewall and a lower sidewall, and wherein in a cross-section of the channel determined by a plane defined by the first direction and the vertical direction, the upper sidewall and the lower sidewall converge to form a V-shaped configuration, with a vertex formed by the upper sidewall and the lower sidewall being oriented toward an interior of the channel.

According to example embodiments of the inventive concept, there is provided a semiconductor device. The semiconductor device may include a channel disposed on a substrate and extending in a first direction substantially parallel to an upper surface of the substrate; a gate structure extending in a second direction substantially parallel to the upper surface of the substrate and crossing the first direction, wherein the gate structure surrounds at least a portion of a first end portion in the first direction of the channel; a bit line electrically connected to the channel and extending in a vertical direction substantially perpendicular to the upper surface of the substrate along a sidewall in the first direction of the first end portion of the channel; and a capacitor disposed at a sidewall in the first direction of a second end portion in the first direction of the channel, wherein a first thickness in the vertical direction of the second end portion of the channel remains constant along the first direction and then gradually decreases when approaching the capacitor.

According to example embodiments of the inventive concept, there is provided a semiconductor device. The semiconductor device may include a buried structure on a substrate, the buried structure extending in a vertical direction substantially perpendicular to an upper surface of the substrate and in a first direction substantially parallel to the upper surface of the substrate; a channel extending in a second direction substantially parallel to the upper surface of the substrate and crossing the first direction, wherein the channel at least partially penetrates the buried structure; a gate structure extending in the first direction and surrounding at least a portion of a first end portion in the second direction of the channel; a bit line electrically connected to the channel and extending in the vertical direction along a sidewall in the second direction of the first end portion of the channel; and a capacitor disposed at a sidewall in the second direction of a second end portion of the channel, the second end portion of the channel being an end portion in the second direction of the channel facing (e.g., opposite to) the first end portion of the channel, wherein the sidewall in the second direction of the second end portion of the channel includes an upper sidewall and a lower sidewall, the upper sidewall and the lower sidewall having slopes inclined in opposite directions with respect to the upper surface of the substrate, and wherein a first distance in the second direction between the sidewall in the second direction of the second end portion of the channel and the capacitor is greater than a second distance in the second direction between a sidewall in the second direction of the buried structure and the capacitor.

The semiconductor device in accordance with example embodiment may have a large contact surface between a channel and an ohmic contact, or between a channel and a source/drain layer, and accordingly, contact resistance therebetween may be reduced.

### BRIEF DESCRIPTION OF THE DRAWINGS

FIGS. 1 to 6 are a perspective view, a horizontal cross-sectional view, and vertical cross-sectional views illustrating a semiconductor device in accordance with example embodiments.
FIGS. 7 to 46 are vertical cross-sectional views and horizontal cross-sectional views illustrating a method of manufacturing a semiconductor device in accordance with example embodiments.
FIG. 47 is a vertical cross-sectional view illustrating a semiconductor device in accordance with example embodiments.
FIG. 48 is a vertical cross-sectional view illustrating a semiconductor device in accordance with example embodiments.
FIG. 49 is a vertical cross-sectional view illustrating a semiconductor device in accordance with example embodiments.
FIG. 50 is a vertical cross-sectional view illustrating a semiconductor device in accordance with example embodiments.
FIG. 51 is a vertical cross-sectional view illustrating a semiconductor device in accordance with example embodiments.
FIG. 52 is a vertical cross-sectional view illustrating a semiconductor device in accordance with example embodiments.
FIG. 53 is a vertical cross-sectional view illustrating a semiconductor device in accordance with example embodiments.

### DETAILED DESCRIPTION OF THE EMBODIMENTS

The above and other aspects and features of the semiconductor devices and the methods of manufacturing the same in accordance with example embodiments will become readily understood from detail descriptions that follow, with reference to the accompanying drawings. It will be understood that, although the terms "first," "second," and/or "third" may be used herein to describe various materials, layers, regions, pads, electrodes, patterns, structure and/or processes, these various materials, layers, regions, pads, electrodes, patterns, structure and/or processes should not be limited by these terms. These terms are only used to distinguish one material, layer, region, pad, electrode, pattern, structure or process from another material, layer, region, pad, electrode, pattern, structure or process. Thus, "first", "second" and/or "third" may be used selectively or interchangeably for each material, layer, region, electrode, pad, pattern, structure or process respectively.

Two directions among horizontal directions that are substantially parallel to an upper surface of the substrate, which intersect each other, may be referred to as first and second directions D1 and D2, respectively, and a direction substantially vertical to the upper surface of the substrate may be referred to as a third direction D3. In example embodiments, the first and second directions D1 and D2 may be substantially perpendicular to each other. Each of the first to third directions D1, D2 and D3 may include not only a direction shown in the drawings but also a direction opposite thereto. The terms "upper" and "lower" may refer to relative positions in the third direction D3 (e.g., relative distances from the substrate). For instance, an upper portion of a component may be located further along the third direction D3 (e.g. further from the substrate) than a lower portion of the component. While the terms "horizontal", "vertical", "upper", "lower", etc. are used herein, it will be appreciated that these terms relate to directions and positions defined relative to the structure of the device, and need not limit the device to any particular orientation in use.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

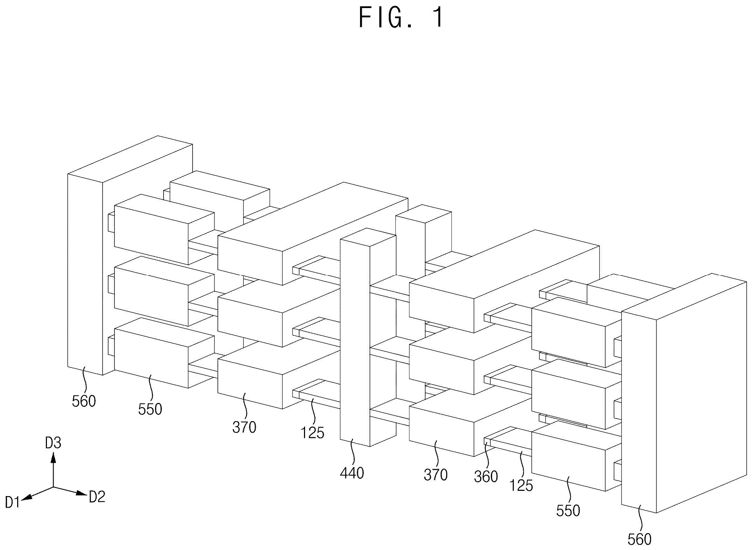

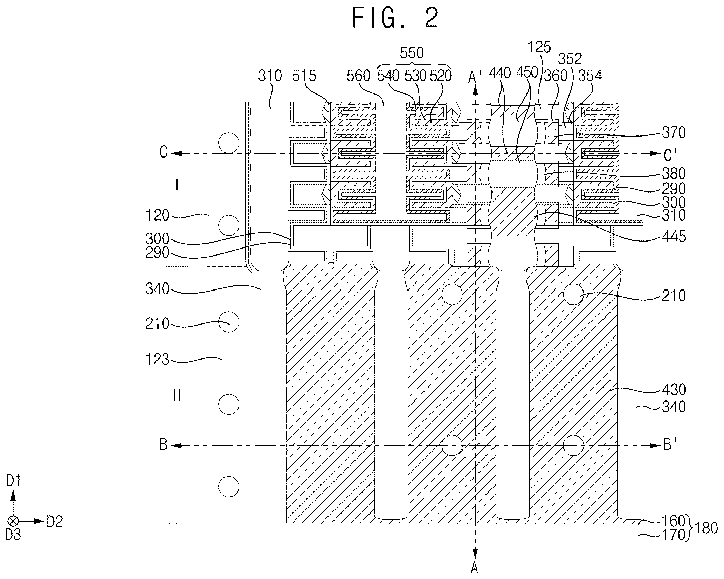

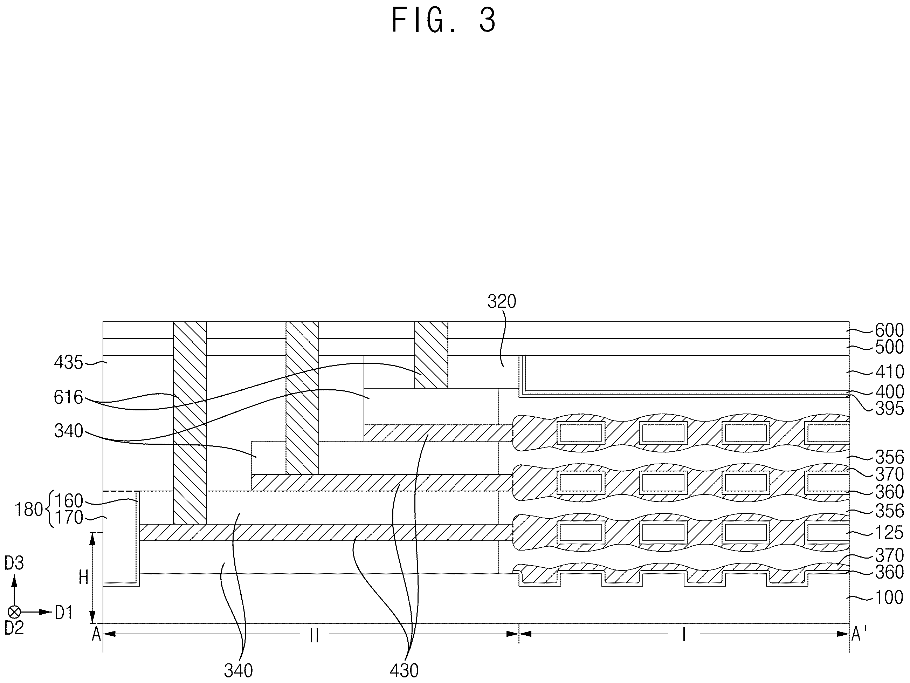

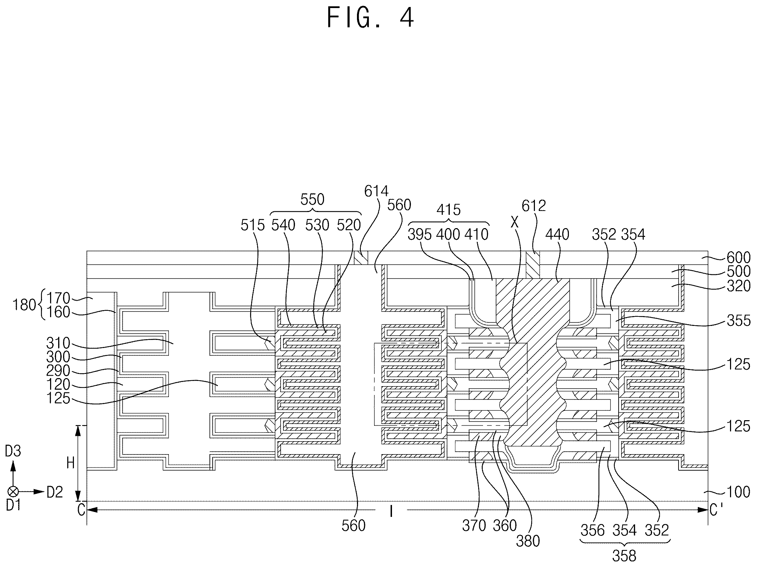

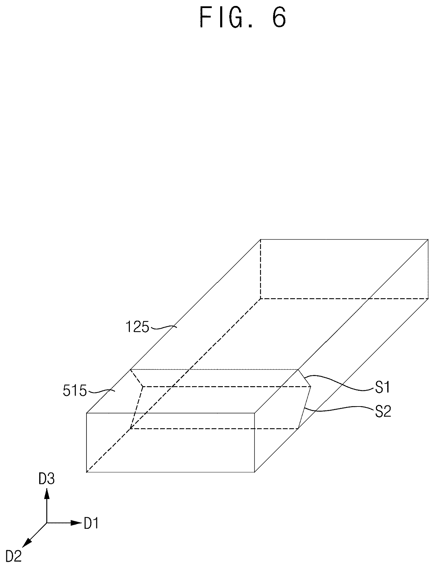

FIGS. 1 to 6 are a perspective view, a horizontal cross-sectional view, and vertical cross-sectional views illustrating a semiconductor device in accordance with example embodiments. Particularly, FIG. 1 is a perspective view of FIGS. 2 to 5 and is a schematic diagram showing main elements of the semiconductor device. FIG. 2 is a horizontal cross-sectional view at a height H of FIGS. 3 and 4. FIGS. 3 and 4 are vertical cross-sectional views taken along lines A-A' and C-C' of FIG. 2, respectively. FIG. 6 is an enlarged perspective view of a channel and an ohmic contact of the semiconductor device.

Referring to FIGS. 1 to 6, the semiconductor device may include a memory cell region in which memory cells are formed and a peripheral circuit region in which circuit patterns for applying electrical signals to the memory cells are formed. The memory cell region may include memory cell block regions each of which may include memory cells. The memory cell block regions may be arranged in each of the first and second directions D1 and D2, and may be separated from each other by a first division structure 180.

The first division structure 180 may contact an upper surface of the memory cell region of the substrate 100, and may have a lattice shape in a plan view. In an example embodiment, the first division structure 180 may include a first division pattern 160 and a second division pattern 170. The first division pattern 160 may cover a sidewall and a lower surface of the second division pattern 170. The second division pattern 170 may contact the first division pattern 160. The first division pattern 160 may be formed of or include an insulating nitride, e.g., silicon nitride, and the second division pattern 170 may be formed of or include an oxide, e.g., silicon oxide.

Each of the memory cell block regions may include first and second regions I and II. The first region I may be a memory cell array region in which a memory cell array including the memory cells is formed, and the second region II may be a pad region or an extension region in which contact plugs for transferring electrical signals to the memory cell array or conductive pads contacting the contact plugs are formed.

In example embodiments, the second region II may be disposed at one side or two opposite sides in the first direction D1 of the first region I. FIG. 2 shows a portion of the memory cell block region, that is, a portion of each of the first and second regions I and II.

The semiconductor device may include channels 125, gate structures, bit lines 440, ohmic contacts 515, capacitor structures, conductive pads 430, and first to third contact plugs 612, 614, and 616.

Additionally, the semiconductor device may include a dummy bit line 445, a first division structure 180, a third division structure, a buried structure 358, a fourth division structure 415, support patterns 210, semiconductor layers 120, semiconductor patterns 123, a second mask 320, an eighth division pattern 340, eleventh division patterns 450, second and third insulating interlayers 435 and 600, and a capping layer 500 on the substrate 100.

The substrate 100 may include a semiconductor material, e.g., silicon, germanium, silicon-germanium, etc., or a III-V group compound semiconductor, such as GaP, GaAs, GaSb, etc. In an example embodiment, the substrate 100 may be a silicon-on-insulator (SOI) substrate or a germanium-on-insulator (GOI) substrate.

The channels 125 may extend lengthwise in the second direction D2 on the first region I of the substrate 100. The channels 125 may be spaced apart from each other along the first and second directions D1 and D2 at substantially the same height from the upper surface of the substrate 100, and may be disposed along the third direction D3. Each of channel columns may include a group of the channels 125 spaced apart from each other along the first direction D1 at substantially the same height, and the channel columns may be disposed along the second and third directions D2 and D3. Each of channel arrays may include a group of the channel columns spaced apart from each other along the second direction D2 at substantially the same height, and the channel arrays may be disposed along the third direction D3.

In example embodiments, portions of first end portions of the channels 125 facing the bit lines 440 may form first source/drain regions SDR1. In example embodiments, portions of second end portions of the channels 125 facing the capacitors 550 may form second source/drain regions SDR2. The first end portions may be opposite the second end portions (e.g., may be opposite ends of the channels). Each of the first and second source/drain regions SDR1 and SDR2 may further include n-type impurities or p-type impurities.

In example embodiments, a sidewall in the second direction D2 of a second end portion of a channel 125 may have a concave shape. In example embodiments, the sidewall in the second direction D2 of the second end portion of the channel 125 may be positioned inwardly compared to a sidewall in the second direction D2 of the buried structure 358. In example embodiments, a distance in the second direction D2 between the sidewall in the second direction D2 of the second end portion of the channel 125 and the capacitor 550 may be greater than a distance in the second direction D2 between the sidewall in the second direction D2 of the buried structure 358 and the capacitor 550.

Hereinafter, for convenience of explanation, an upper sidewall in the second direction D2 of the second end portion of the channel 125 will be referred to as a first sidewall S1, and a lower sidewall in the second direction D2 of the second end portion of the channel 125 will be referred to as a second sidewall S2. In example embodiments, the first and second sidewalls S1 and S2 of the channel 125 may be inclined in opposite directions with respect to the upper surface of the substrate 100. In example embodiments, in a cross-section of the channel 125 determined by the second and third directions D2 and D3, the first and second sidewalls S1 and S2 may converge to form a V-shaped configuration, and a vertex formed by the first and second sidewalls S1 and S2 may be oriented toward an interior of the channel 125. In example embodiments, the first and second sidewalls S1 and S2 may face each other in the third direction D3. In example embodiments, the vertex where the first and second sidewalls S1 and S2 meet may be sharp. For example, the vertex where the first and second sidewalls S1 and S2 meet may be a point.

The semiconductor layers 120 may extend in the first direction D1 at each of opposite sides in the second direction D2 of the first region I of the substrate 100. In example embodiments, the semiconductor layers 120 and the channels 125 may be disposed at substantially the same height from the upper surface of the substrate 100.

The semiconductor patterns 123 may extend lengthwise in the first direction D1 at each of opposite sides in the second direction D2 of the second region II of the substrate 100. The semiconductor patterns 123 may contact and be connected to the semiconductor layers 120.

The channels 125, the semiconductor layers 120, and the semiconductor patterns 123 may be formed of or include substantially the same material, e.g., a semiconductor material such as silicon.

The gate structures may extend lengthwise in the first direction D1 and may be spaced apart from each other along the second and third directions D2 and D3. In example embodiments, a gate structure may extend in the first direction D1 while surrounding upper and lower surfaces and opposite sidewalls in the first direction D1 of the first end portions in the second direction D2 of the channels 125 of a corresponding channel column on the first region I of the substrate 100. The gate structures may serve as word lines of the semiconductor device.

The gate structures may include gate electrodes 370, gate insulation patterns 360, and gate masks 380. In example embodiments, the gate structure may include a group of the gate insulation patterns 360 covering surfaces of the first end portions of the channels 125 of the corresponding channel column, and a gate electrode 370 and a gate mask 380 surrounding the group of the gate insulation patterns 360.

The gate insulation patterns 360 may cover lower and upper surfaces and opposite sidewalls in the first direction D1 of the first end portions of the channels 125. In example embodiments, the gate insulation patterns 360 may contact the first end portions of the channels 125 of the corresponding channel columns. The gate insulation patterns 360 may be formed of or include an oxide, e.g., silicon oxide.

The gate electrode 370 may extend lengthwise in the first direction D1, and may cover lower and upper surfaces and opposite sidewalls in the first direction D1 of portions of the gate insulation patterns 360 arranged in the first direction D1. For example, the gate electrodes 370 may contact the lower and upper surfaces and opposite sidewalls of portions of the gate insulation patterns 360. The gate electrodes 370 may contact the channels 125. The gate electrodes 370 may be formed of or include a conductive material, e.g., a metal, a metal nitride, silicide, etc.

The gate mask 380 may contact a sidewall in the second direction D2 of the gate electrode 370, may extend in the first direction D1, and may cover lower and upper surfaces and opposite sidewalls in the first direction D1 of portions of the gate insulation patterns 360 arranged in the first direction D1. The gate mask 380 may contact the lower and upper surfaces and opposite sidewalls of portions of the gate insulation patterns 360. The gate mask 380 may contact the channels 125. The gate masks 380 may be formed of or include an insulating nitride, e.g., silicon nitride.

The conductive pads 430 may extend lengthwise in the first direction D1 on the second region II of the substrate 100, and may be spaced apart from each other in the second direction D2. In example embodiments, at least a portion of a conductive pad 430 may be disposed at substantially the same height as the gate electrode 370, and may contact a sidewall in the first direction D1 of the gate electrode 370 to be electrically connected thereto. In example embodiments, the conductive pads 430 may overlap the gate structures and the channels 125 in the first direction D1.

In example embodiments, the conductive pads 430 may be spaced apart from each other in the third direction D3, and lengths in the first direction D1 of the conductive pads 430 may decrease from a lowermost one to an uppermost one thereof in a stepwise manner. Thus, the conductive pads 430 disposed in the third direction D3 may form a staircase structure.

The conductive pads 430 may be formed of or include a conductive material, e.g., a metal, a metal nitride, a silicide, doped polysilicon, etc.

In example embodiments, the third division structure may include first and second insulation patterns 290 and 300 and a seventh division pattern 310.

Hereinafter, for convenience of explanation, ones of the channels 125 adjacent to the semiconductor layers 120 in the second direction D2 will be referred to as first channels.

The third division structure may fill spaces between the semiconductor layers 120 and the first channels that are stacked in the third direction D3, between the upper surface of the substrate 100 and each of a lowermost semiconductor layer 120 and a lowermost first channel, and between the second mask 320 and each of an uppermost semiconductor layer 120 and an uppermost first channel. Additionally, the third division structure may fill spaces between the semiconductor layers 120 and the first channels neighboring in the second direction D2. Additionally, the third division structure may fill spaces between the first channels adjacent to each other in the first direction D1 on the memory cell region of the substrate 100.

The first and second insulation patterns 290 and 300 may be sequentially stacked on surfaces of the first division structure 180, the semiconductor layers 120 and the first channels, and the seventh division pattern 310 may be disposed on the second insulation pattern 300 and fill other portions of the spaces.

The first insulation pattern 290 and the seventh division pattern 310 may be formed of or include an oxide, e.g., silicon oxide, and the second insulation pattern 300 may be formed of or include an insulating nitride, e.g., silicon nitride.

In example embodiments, the buried structure 358 may include first to third buried patterns 352, 354, and 356.

The buried structure 358 may fill spaces between the gate structures, between the upper surface of the substrate 100 and each of a lowermost gate structure and a lowermost channel 125, and between the second mask 320 and each of an uppermost gate structure and an uppermost channel 125. Additionally, the buried structure 358 may fill spaces between the channels 125 neighboring in the first direction D1.

The buried structure 358 may have a plate-like shape extending in the first and third directions D1 and D3, and the channels 125 and the ohmic contacts 515 at sidewalls in the second direction D2 of the channels 125 may together extend through the buried structure 358. The buried structure 358 may contact the channels 125 and the ohmic contacts 515.

The first and second buried patterns 352 and 354 may be sequentially stacked on surfaces of the channels 125, and the third buried pattern 356 may be disposed on the second buried pattern 354 to fill remaining spaces. The third buried pattern 356 may contact the gate insulation patterns 360, the gate electrode 370, and the bit lines 440.

The first buried pattern 352 and the third buried pattern 356 may be formed of or include an oxide, for example, silicon oxide, and the second buried pattern 354 may be formed of or include an insulating nitride, for example, silicon nitride.

The eighth division pattern 340 may be disposed on the second region II of the substrate 100, and may fill spaces between the conductive pads 430 and the semiconductor patterns 123 that are stacked in the third direction D3, between the upper surface of the substrate 100 and each of a lowermost conductive pad 430 and a lowermost semiconductor pattern 123, and between the second mask 320 and each of an uppermost conductive pad 430 and an uppermost semiconductor pattern 123. The eighth division pattern 340 may contact the conductive pads 430, the second mask 320, and the semiconductor patterns 123. In addition, the eighth division pattern 340 may contact the seventh division pattern 310 and the third buried pattern 356. In example embodiments, lengths in the first direction D1 of horizontal portions of the eighth division pattern 340 disposed in the third direction D3 may decrease from a lowermost one to an uppermost one in a stepwise manner, and thus a stack structure including the eighth division pattern 340 may be a staircase structure. In example embodiments, a horizontal portion of the eighth division patterns 340 on a corresponding one of the conductive pads 430 may collectively form one step layer, and a sidewall in the first direction D1 of the horizontal portion of the eighth division patterns 340 may be aligned with a sidewall in the first direction D1 of the corresponding one of the conductive pads 430 in the third direction D3.

The eighth division pattern 340 may be formed of or include an insulating nitride, e.g., silicon nitride.

The support patterns 210 may be spaced apart from each other along the first direction D1 at opposite sides in the second direction D2 of the first region I of the substrate 100, and may also be spaced apart from each other along the first and second directions D1 and D2 on the second region II of the substrate 100. The support patterns 210 may extend through the semiconductor layers 120, the third division structure, the eighth division pattern 340 and the conductive pads 430 to contact the upper surface of the substrate 100.

The support patterns 210 may be formed of or include an insulating nitride, e.g., silicon nitride, and may be merged with the eighth division pattern 340.

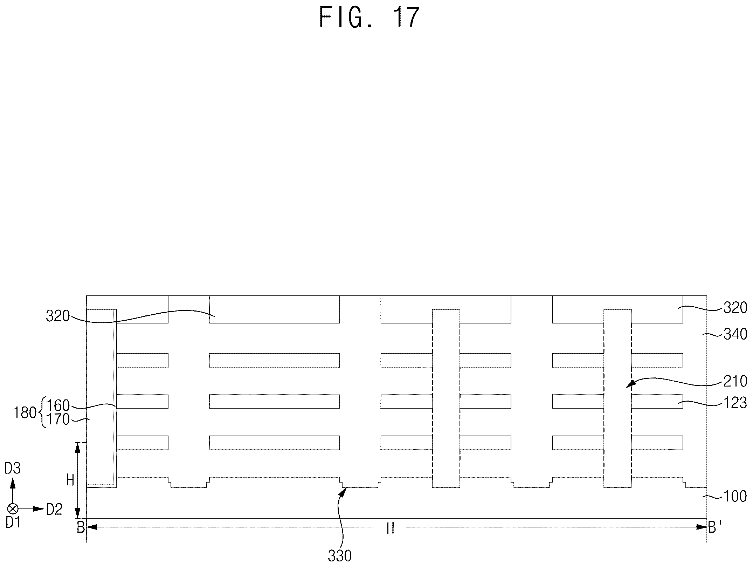

The second mask 320 may be disposed on the third division structure and the eighth division pattern 340. However, referring to FIG. 17 together with FIGS. 1 to 6, the eighth division pattern 340 may cover a sidewall of the second mask 320, and thus an upper surface of the second mask 320 may be substantially coplanar with upper surfaces of the eighth division pattern 340. The second mask 320 may be formed of or include an insulating nitride, e.g., silicon nitride.

The second insulating interlayer 435 may be disposed on the eighth division pattern 340 on the second region II of the substrate 100. In example embodiments, an upper surface of the second insulating interlayer 435 may be substantially coplanar with the upper surface of the second mask 320. The second insulating interlayer 435 may be formed of or include an oxide, e.g., silicon oxide.

The fourth division structure 415 may extend in the first direction D1 between the channels 125 neighboring in the second direction D2. In example embodiments, a lower portion of the fourth division structure 415 may be disposed on the gate insulation pattern 360 covering the upper surface of the substrate 100 in the first region I. In example embodiments, an upper surface of an upper portion of the fourth division structure 415 may be substantially coplanar with the upper surface of the second mask 320.

The fourth division structure 415 may include a ninth division pattern 410 and fourth and third insulation patterns 400 and 395 covering a sidewall and a lower surface of the ninth division pattern 410. The third insulation pattern 395 may extend in the first direction D1 while covering a surface of a gate insulation pattern 360 on the upper surface of the substrate 100, surfaces of the gate masks 380 covering the gate insulation patterns 360, a sidewall of the third buried pattern 356, and a sidewall of the second mask 320.

The third insulation pattern 395 and the ninth division pattern 410 may be formed of or include an oxide, e.g., silicon oxide, and the fourth insulation pattern 400 may be formed of or include an insulating nitride, e.g., silicon nitride.

The bit lines 440 may extend in the third direction D3 partially through the fourth division structure 415 extending lengthwise in the first direction D1 on the first region I of the substrate 100, and may be spaced apart from each other in the first direction D1. Eleventh division patterns 450 including an oxide, e.g., silicon oxide may extend partially through the fourth division structure 415 between ones of the bit lines 440 neighboring in the first direction D1, so that the bit lines 440 may be separated from each other by the eleventh division patterns 450. The dummy bit line 445 may be disposed on a portion of the first region I adjacent to the second region II of the substrate 100.

In example embodiments, the bit lines 440 and the dummy bit line 445 may contact the channels 125 that are disposed in the third direction D3 at opposite sides in the second direction D2 of the bit lines 440 and the dummy bit line 445. The bit lines 440 and the dummy bit line 445 may contact sidewalls in the second direction D2 of the gate insulation patterns 360 and the gate masks 380 that may surround the first end portions of the channels 125.

In an example embodiment, each of the bit lines 440 and the dummy bit line 445 may be formed of or include, e.g., polysilicon doped with n-type impurities. Alternatively, each of the bit lines 440 and the dummy bit line 445 may be formed of or include, e.g., a metal, a metal nitride, a metal silicide, etc.

The ohmic contacts 515 may be disposed at sidewalls in the second direction D2 of the second end portions of the channels 125. Accordingly, the ohmic contacts 515 may be spaced apart from each other along the first and second directions D1 and D2 at the same height from the upper surface of the substrate 100, and may be disposed along the third direction D3.

In example embodiments, an ohmic contact 515 may contact the first and second sidewalls S1 and S2 in the second direction D2 of the second end portion of the channel 125. Accordingly, a sidewall in the second direction D2 of the ohmic contact 515 facing the second end portion of the channel 125 may have a convex shape, corresponding to the sidewall in the second direction D2 of the second end portion of the channel 125.

In example embodiments, a cross-section of the ohmic contact 515 determined by a plane defined by the second and third directions D2 and D3 may have a pentagonal shape. In example embodiments, the ohmic contact 515 may have a pentagonal column shape extending in the first direction D1.

In example embodiments, the ohmic contacts 515 may overlap with the buried structure 358 in the third direction D3. In example embodiments, sidewalls in the second direction D2 of the ohmic contact 515 facing the capacitors 550 may be aligned with the sidewall in the second direction D2 of the buried structure 358 facing the capacitors 550 in the third direction D3.

The ohmic contacts 515 may be formed of or include a silicide, e.g., tungsten silicide, molybdenum silicide, titanium silicide, cobalt silicide, nickel silicide, platinum silicide, etc.

The capacitor structures may include capacitors 550 and plate electrodes 560, and the capacitors 550 may include first capacitor electrodes 520, second capacitor electrodes 540, and dielectric patterns 530. In example embodiments, a capacitor 550 may include a first capacitor electrode 520, and portions of a dielectric pattern 530 and a second capacitor electrode 540 sequentially stacked on a surface of the first capacitor electrode 520. In example embodiments, a capacitor structure may include a plate electrode 560 and the capacitors 550 at opposite sidewalls in the second direction D2 of the plate electrode 560.

The first capacitor electrodes 520 may be disposed at the sidewalls of the ohmic contacts 515 and may extend in the second direction D2. Accordingly, the first capacitor electrodes 520 may be spaced apart from each other along the first and second directions D1 and D2 at the same height from the upper surface of the substrate 100, and may be disposed along the third direction D3.

In example embodiments, each of the first capacitor electrodes 520 may have, for example, a shape of a hollow rectangular parallelepiped opened at a first face opposite to a second face that contacts the ohmic contact 515.

In example embodiments, the dielectric patterns 530 and the second capacitor electrodes 540 may be sequentially stacked in spaces between the first capacitor electrodes 520 that are stacked in the third direction D3, between the upper surface of the substrate 100 and a lowermost first capacitor electrode 520, and between the second mask 320 and an uppermost first capacitor electrode 520 on the first region I of the substrate 100. The dielectric patterns 530 and the second capacitor electrodes 540 may be sequentially stacked on surfaces of the first capacitor electrodes 520, surfaces of the ohmic contacts 515, and the sidewalls in the second direction D2 of the buried structure 358.

In example embodiments, the plate electrodes 560 may fill a remaining portion of the spaces and a space between the channels 125 neighboring in the second direction D2. Thus, the plate electrode 560 may include a vertical extension portion extending in the third direction D3 and horizontal extension portions extending from opposite sidewalls in the second direction D2 of the vertical extension portion. The capacitor structures may extend in the first direction D1 on the first region I of the substrate 100.

In example embodiments, the capacitor structures may extend through the capping layer 500 and the third division structure. Accordingly, the capacitor structures may be disposed at an opposite side in the second direction D2 of the bit lines 440 with respect to the channels 125.

The first and second capacitor electrodes 520 and 540 may be formed of or include a metal, e.g., titanium, tantalum, etc., or a metal nitride, e.g., titanium nitride, tantalum nitride, etc. The dielectric patterns 530 may be formed of or include a metal oxide having a high dielectric constant, e.g., hafnium oxide, zirconium oxide, etc. The plate electrodes 560 may be formed of or include, e.g., doped or undoped silicon-germanium.

Each of the memory cells may include the word line and the bit line 440 extending respectively in the first and second directions D1 and D2, the channel 125 surrounded by the word line and contacting the bit line 440, and the capacitor 550 electrically connected to the channel 125 on the first region I of the substrate 100. The memory cells may be arranged not only along the first and second directions D1 and D2 on the first region I of the substrate 100, but also in the third direction D3. The memory cells may be DRAM memory cells. Accordingly, the semiconductor device may be a DRAM device.

The capping layer 500 may be disposed on the second mask 320, the second insulating interlayer 435 and the fourth division structure 415 on the substrate 100, and may cover a sidewall of upper portions of the capacitor structures. The capping layer 500 may be formed of or include an insulating nitride, e.g., silicon nitride.

The third insulating interlayer 600 may be disposed on the capping layer 500.

The first contact plugs 612 may extend through the third insulating interlayer 600 and the capping layer 500 to contact upper surfaces of the bit lines 440. The second contact plugs 614 may extend through the third insulating interlayer 600 to contact upper surfaces of the plate electrodes 560 of the capacitor structures. The third contact plugs 616 may extend through the third insulating interlayer 600, the capping layer 500, the second mask 320, and the eighth division pattern 340 or extend through the third insulating interlayer 600, the capping layer 500, and the second insulating interlayer 435 to contact upper surfaces of the conductive pads 430.

In the semiconductor device, the first and second sidewalls S1 and S2 of the channels 125 may be inclined in opposite directions with respect to the upper surface of the substrate 100, and the ohmic contacts 515 may be in contact with the first and second sidewalls S1 and S2 of the channels 125. Accordingly, compared to when the sidewalls in the second direction D2 of the channels 125 are not inclined but perpendicular with respect to the upper surface of the substrate 100, the channels 125 and the ohmic contacts 515 may provide a wider contact surface, thereby reducing contact resistance therebetween.

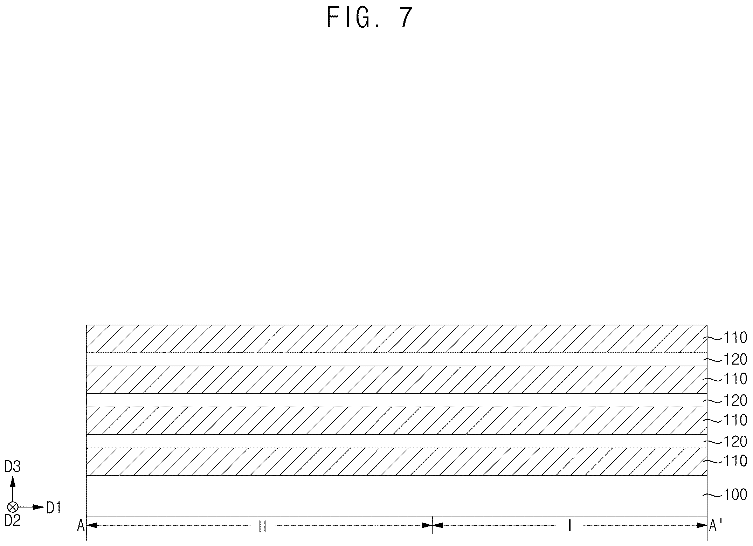

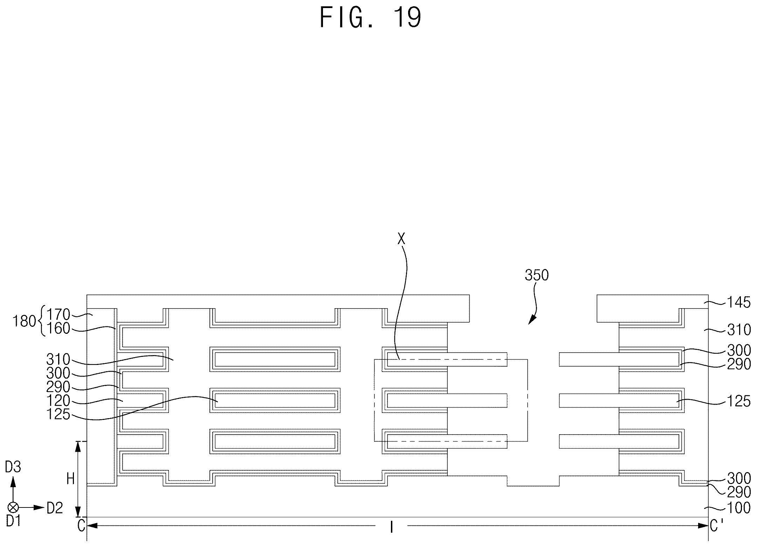

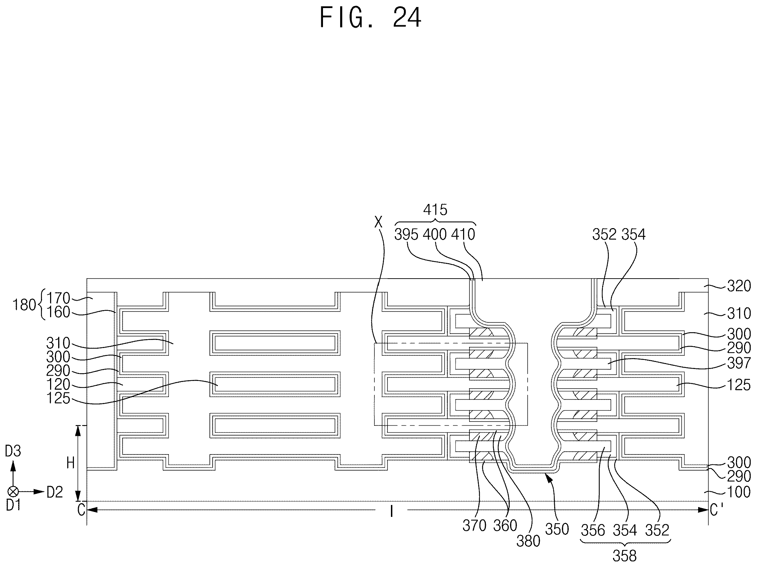

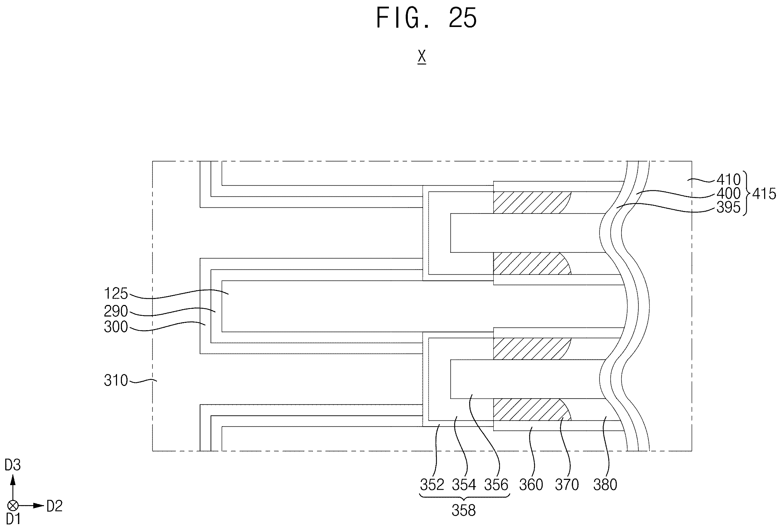

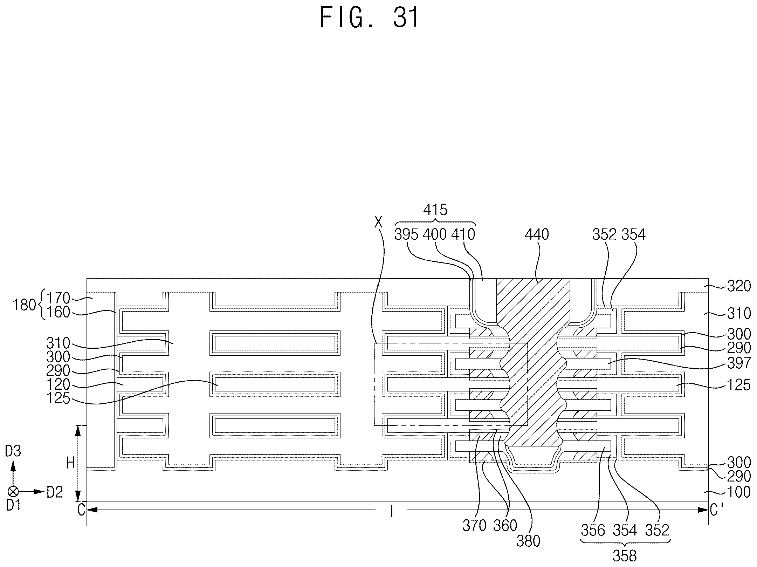

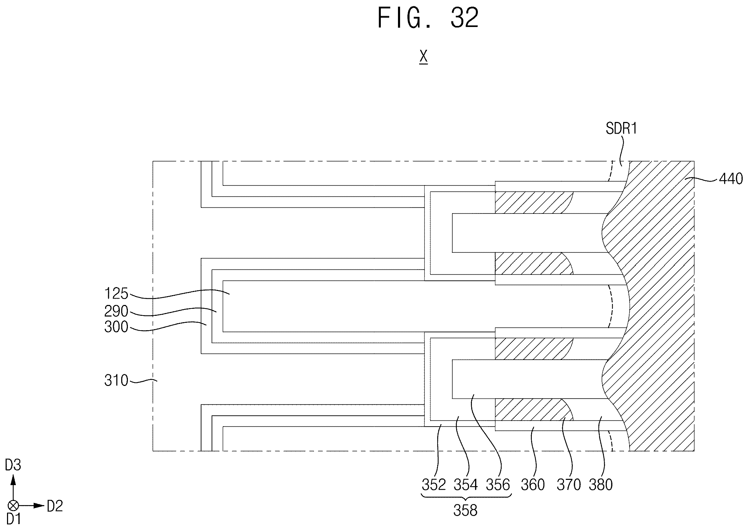

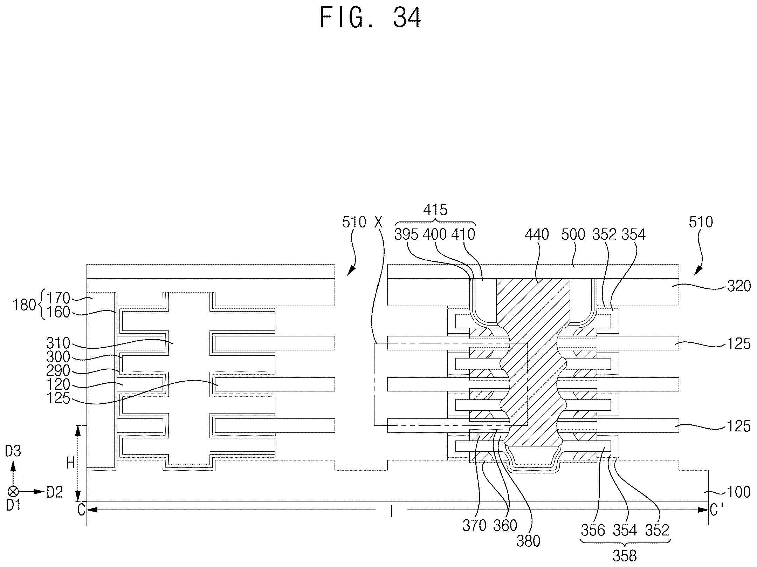

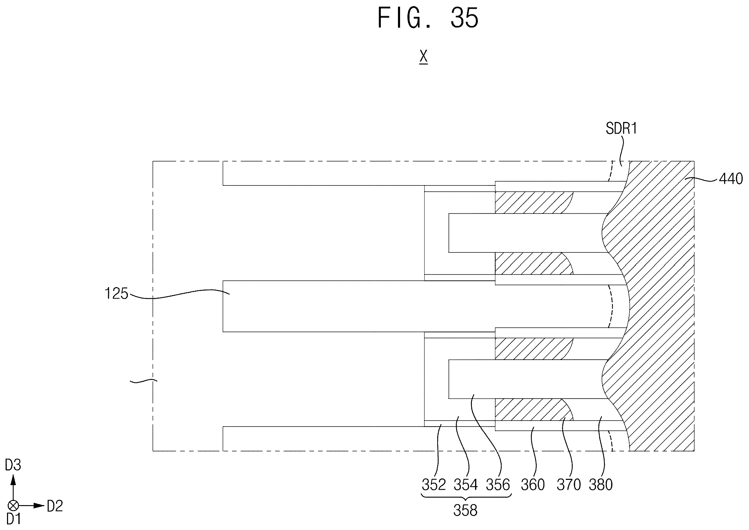

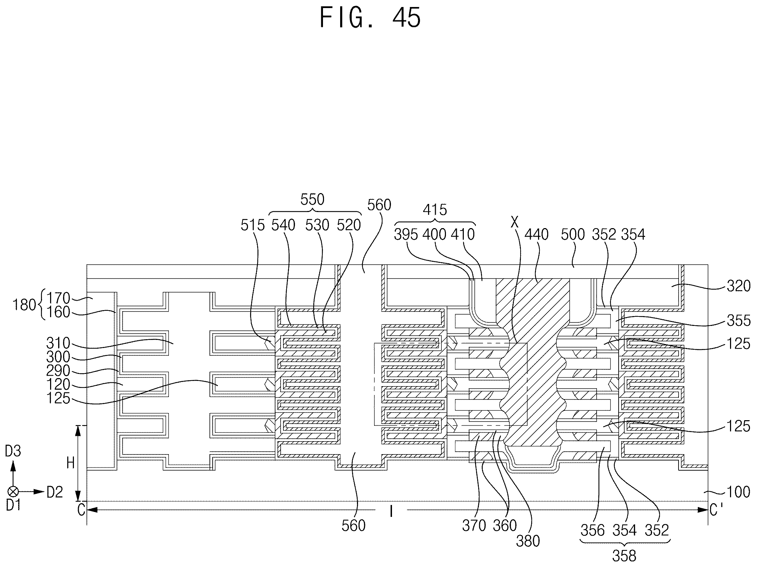

FIGS. 7 to 45 are vertical cross-sectional views, horizontal cross-sectional views and enlarged perspective views illustrating a method of manufacturing a semiconductor device in accordance with example embodiments.

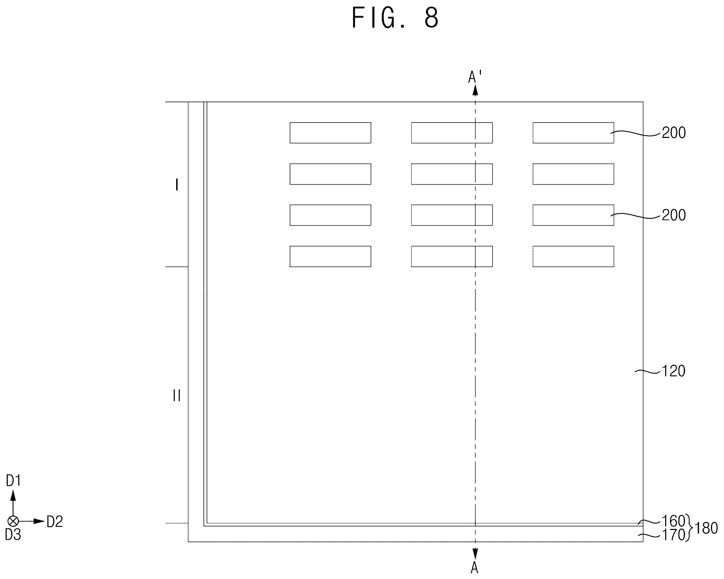

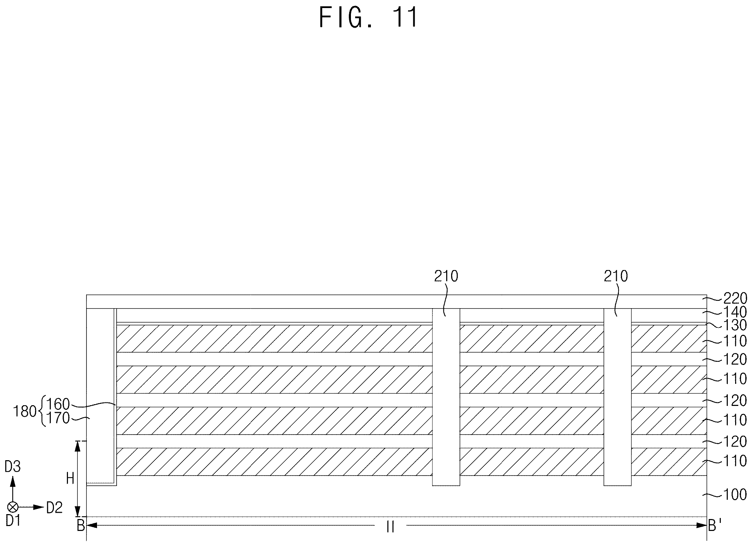

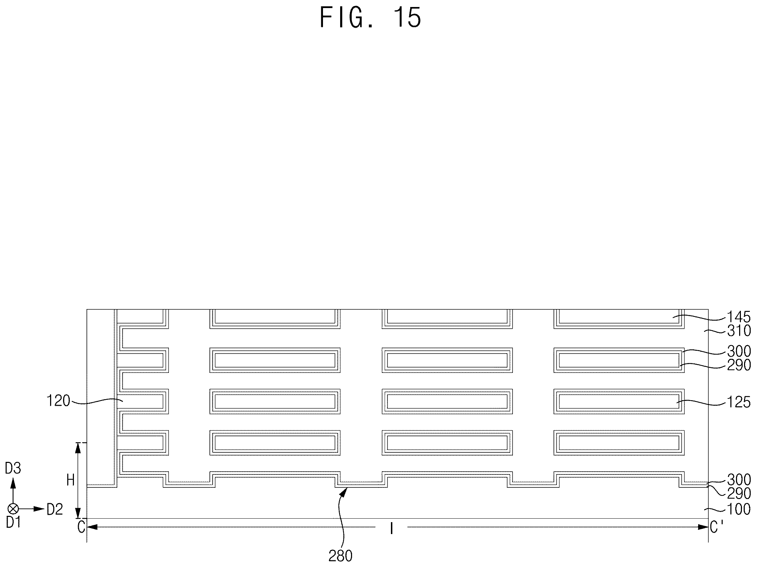

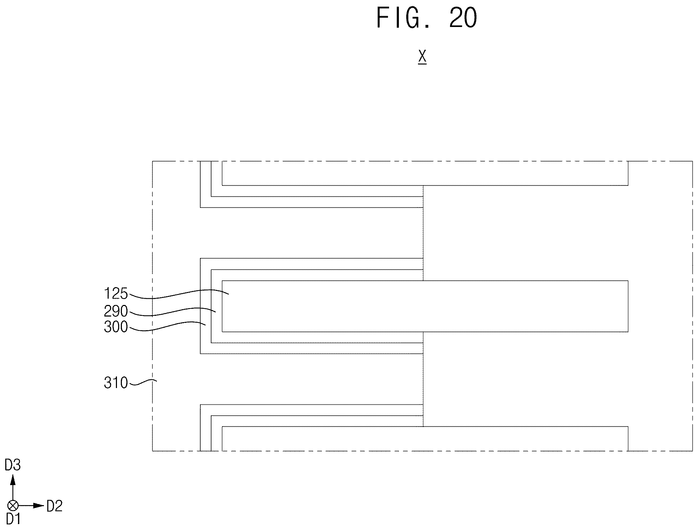

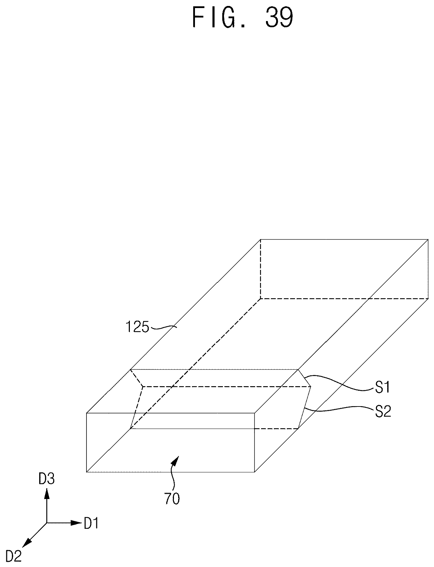

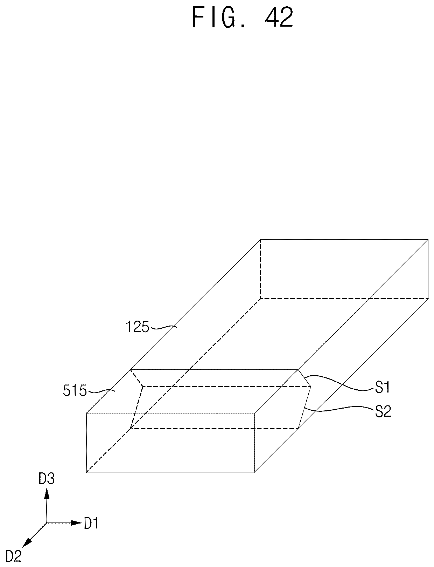

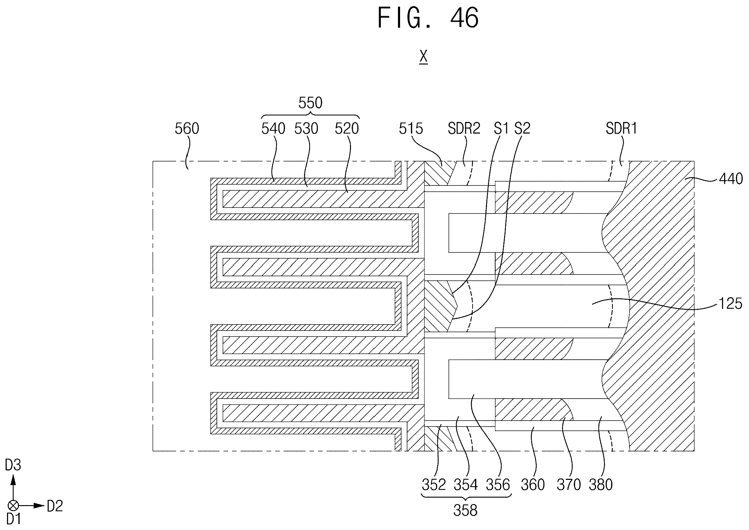

Particularly, FIGS. 8, 10, 12, 14, 16, 18, 23, 26, 28, 30, 33, and 44 are horizontal cross-sectional views at a height H of corresponding vertical cross-sectional views, respectively. FIGS. 7, 9, and 29 are vertical cross-sectional views taken along lines A-A' of corresponding horizontal cross-sectional views, respectively. FIGS. 11, 13, 17, and 27 are vertical cross-sectional views taken along lines B-B' of corresponding horizontal cross-sectional views, respectively. FIGS. 15, 19, 24, 31, 34, and 45 are vertical cross-sectional views taken along lines C-C' of corresponding horizontal cross-sectional views, respectively. FIGS. 20-22, 25, 32, 35-38, 40-41, 43, and 46 are enlarged cross-sectional views of a region X of corresponding vertical cross-sectional views, respectively. FIGS. 39 and 42 are enlarged perspective views of a channel and/or an ohmic contact.

Referring to FIG. 7, sacrificial layers 110 and semiconductor layers 120 may be alternately and repeatedly stacked on a substrate 100 to form a mold layer.

FIG. 7 shows that the sacrificial layers 110 and the semiconductor layers 120 are stacked at four levels and three levels, respectively, on the substrate 100. However, the inventive concept is not limited thereto, and the sacrificial layers 110 and the semiconductor layers 120 may be stacked at more or less than four levels and three levels, respectively. The uppermost layer of the mold layer may be a sacrificial layer 110.

In example embodiments, the mold layer may be formed by an epitaxial growth process using an upper surface of the substrate 100 as a seed.

In an example embodiment, the semiconductor layers 120 may be formed of or include, e.g., silicon, and the sacrificial layers 110 may include a material having a selectivity with respect to the semiconductor layers 120, e.g., silicon-germanium.

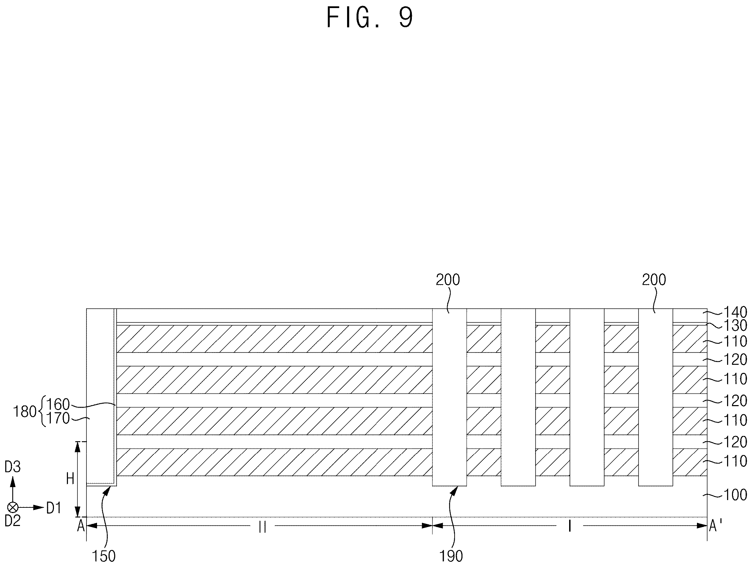

Referring to FIGS. 8 and 9, an insulation pad layer 130 and a first mask layer 140 may be sequentially stacked in the third direction D3 on the mold layer, a dry etching process may be performed on the first mask layer 140, the insulation pad layer 130 and the mold layer to form a first opening 150 exposing the upper surface of the substrate 100, and a first division structure 180 may be formed in the first opening 150.

The insulation pad layer 130 may be formed of or include an oxide, e.g., silicon oxide, and the first mask layer 140 may be formed of or include an insulating nitride, e.g., silicon nitride.

In example embodiments, the first division structure 180 may have a lattice shape in a plan view, and thus a plurality of memory block regions each of which may have, e.g., a rectangular shape may be defined in each of the first and second directions D1 and D2 on the memory cell region of the substrate 100. However, the inventive concept is not limited thereto, and each of the memory block regions may have other shapes in a plan view. FIG. 8 shows a portion of the first division structure 180.

In example embodiments, each of the memory block regions may include first and second regions I and II arranged in the first direction D1.

In an example embodiment, the first division structure 180 may include a first division pattern 160 on a sidewall and a bottom of the first opening 150 and a second division pattern 170 filling a remaining portion of the first opening 150. A sidewall and a lower surface of the second division pattern 170 may be covered by the first division pattern 160. The first division pattern 160 may be formed of or include an insulating nitride, e.g., silicon nitride, and the second division pattern 170 may be formed of or include an oxide, e.g., silicon oxide.

For example, a dry etching process may be performed on the first mask layer 140, the insulation pad layer 130 and the mold layer to form second openings 190 exposing the upper surface of the substrate 100, and third division patterns 200 may be formed in the second openings 190.

In example embodiments, the third division patterns 200 may have a bar shape extending lengthwise in the second direction D2 in a plan view, and may be spaced apart from each other in each of the first and second directions D1 and D2. The third division patterns 200 may be formed of or include an oxide, e.g., silicon oxide.

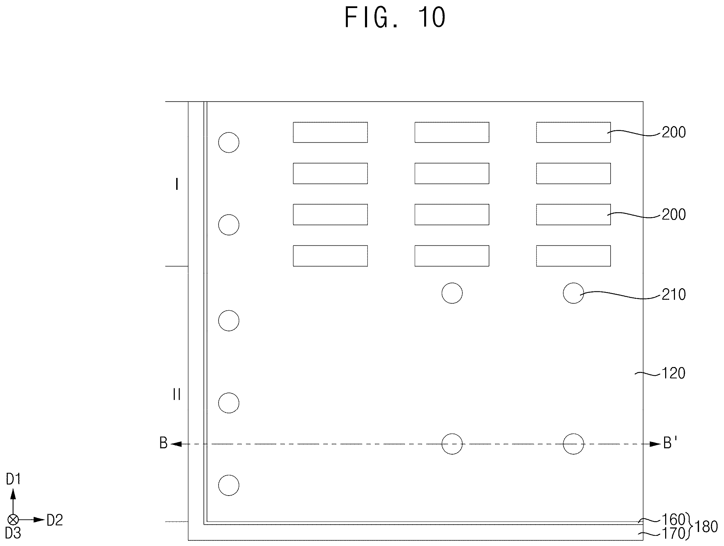

Referring to FIGS. 10 and 11, a dry etching process may be performed on the first mask layer 140, the insulation pad layer 130 and the mold layer to form third openings exposing the upper surface of the substrate 100, and support patterns 210 may be formed in the third openings.

In example embodiments, the support patterns 210 may have a shape of, e.g., a circle, an ellipse, a polygon, a polygon with rounded corners, etc., in a plan view, and may be spaced apart from each other in each of the first and second directions D1 and D2. The support patterns 210 may be formed of or include an insulating nitride, e.g., silicon nitride.

A first insulating interlayer 220 may be formed on the first mask layer 140, the first division structure 180, the third division patterns 200, and the support patterns 210. The first insulating interlayer 220 may contact the first mask layer 140, the first division structure 180, the third division patterns 200, and the support patterns 210. The first insulating interlayer 220 may be formed of or include an oxide, e.g., silicon oxide.

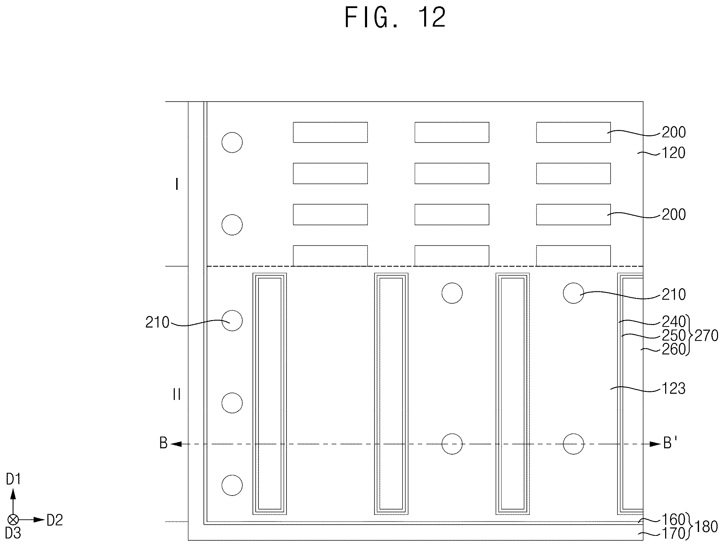

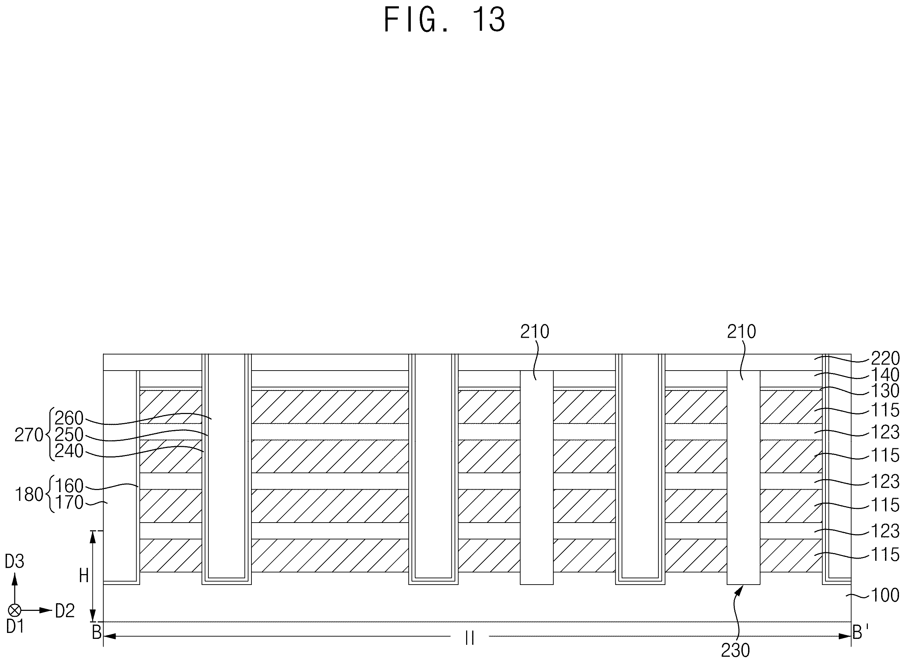

Referring to FIGS. 12 and 13, a dry etching process may be performed on the first insulating interlayer 220, the first mask layer 140, the insulation pad layer 130, and the mold layer to form fourth openings 230 exposing the upper surface of the substrate 100, and second division structures 270 may be formed in the fourth openings 230.

In example embodiments, the second division structures 270 may have a bar shape extending in the first direction D1 in a plan view, and may be spaced apart from each other in the second direction D2. In example embodiments, a second division structure 270 may overlap in the first direction D1 a portion of the mold layer between the third division patterns 200 neighboring in the second direction D2.

In an example embodiment, the second division structure 270 may include fourth to sixth division patterns 240, 250, and 260 sequentially stacked from a sidewall and a bottom of a fourth opening 230. Each of the fourth and sixth division patterns 240 and 260 may be formed of or include an oxide, e.g., silicon oxide, and the fifth division pattern 250 may be formed of or include an insulating nitride, e.g., silicon nitride.

As the second division structures 270 are formed, portions of the sacrificial layers 110 and the semiconductor layers 120 included in a portion of the mold layer on the second region II of the substrate 100 may be transformed into first sacrificial patterns 115 and semiconductor patterns 123, respectively.

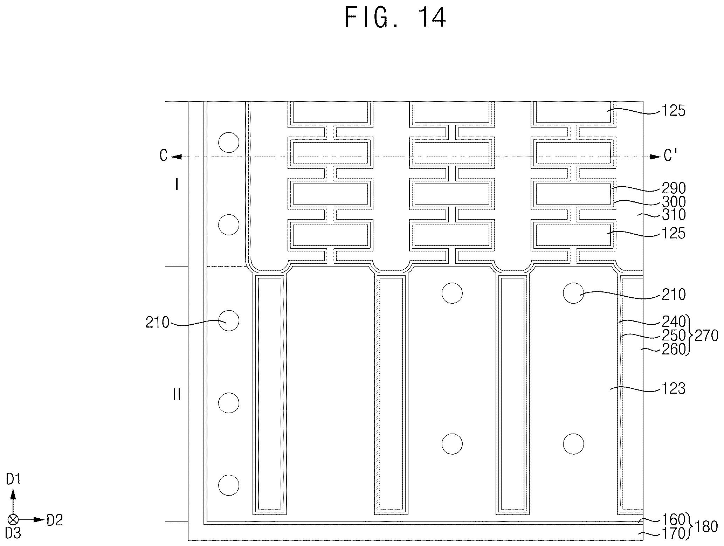

Referring to FIGS. 14 and 15, a dry etching process may be performed on the first insulating interlayer 220, the first mask layer 140, the insulation pad layer 130, and the mold layer to form fifth openings 280 exposing the upper surface of the substrate 100.

In example embodiments, the fifth openings 280 may extend in the first direction D1 between the third division patterns 200 neighboring in the second direction D2, and may be spaced apart from each other in the second direction D2 in the first region I of the substrate 100. A fifth opening 280 may be aligned with the second division structure 270 in the first direction D1, and may extend through a portion of the fourth division pattern 240 at an end portion in the first direction D1 of the second division structure 270 to expose a sidewall of the fifth division pattern 250.

As the fifth openings 280 are formed, portions of the sacrificial layers 110 and the semiconductor layers 120 between the third division patterns 200 neighboring in the first direction D1 and between the fifth openings 280 on the memory cell region of the substrate 100 may be transformed into second sacrificial patterns and channels 125, respectively, and portions of the insulation pad layer 130 and the first mask layer 140 on an uppermost second sacrificial pattern may remain as an insulation pad and a first mask 145.

A wet etching process may be performed through the fifth openings 280 to remove portions of the second sacrificial patterns in the first region I of the substrate 100, and portions of the third division patterns 200 adjacent to the fifth openings 280 in the first region I and the insulation pad may also be removed.

Thus, first gaps may be formed between the channels 125 neighboring in the third direction D3, between an uppermost channel 125 and the first mask 145, and between a lowermost channel 125 and the upper surface of the substrate 100. Additionally, the first gaps may be enlarged in the first direction D1, so that portions of the third division patterns 200 at the same level as the channels 125 may remain, and other portions of the third division patterns 200 may be removed.

First and second insulation layers may be sequentially stacked on inner walls of the first gaps, sidewalls, and bottoms of the fifth openings 280 and the first insulating interlayer 220, a seventh division layer may be formed on the second insulation layer to fill the first gaps and the fifth openings 280, and a planarization process may be performed on the seventh division layer, the first and second insulation layers, the first insulating interlayer 220 and the second division structures 270 until an upper surface of the first mask 145 is exposed. Thus, a third division structure including first and second insulation patterns 290 and 300 and a seventh division pattern 310 may be formed in the first gaps and the fifth openings 280, and the first insulating interlayer 220 may be removed.

The first insulation pattern 290 and the seventh division pattern 310 may be formed of or include an oxide, e.g., silicon oxide, and the second insulation pattern 300 may be formed of or include an insulating nitride, e.g., silicon nitride. The third division pattern 200 remaining between the channels 125 may be merged with the first insulation pattern 290, and hereinafter, the merged structure may be referred to as a first insulation pattern 290. In some embodiments, the first insulation pattern 290 and a portion of the fourth division pattern 240 exposed by the fifth opening 280 may contact each other to be merged with each other.

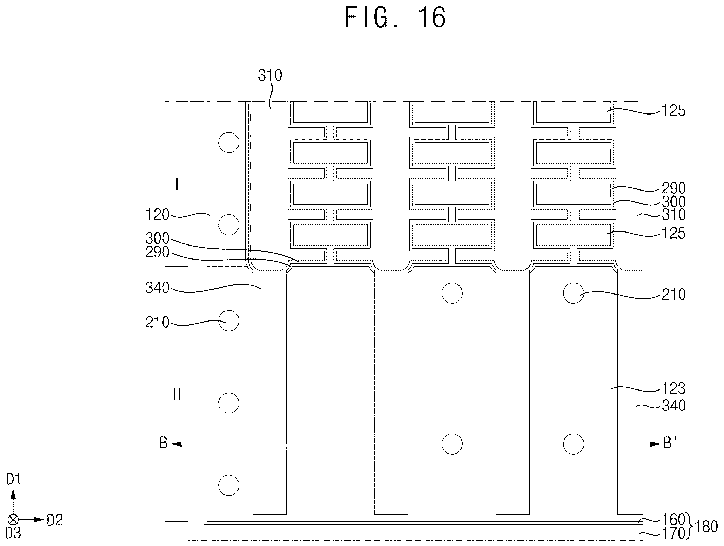

Referring to FIGS. 16 and 17, a second mask 320 may be formed on the first mask layer 140, the first mask 145, the second division structures 270, and the third division structure, a dry etching process may be performed using the second mask 320 as an etching mask to remove the second division structures 270 so that sixth openings 330 exposing the upper surface of the substrate 100 may be formed. Portions of the first sacrificial patterns 115 adjacent to the sixth openings 330 may be removed through the sixth openings 330, and the insulation pad layer 130 may also be removed.

Thus, second gaps may be formed between the semiconductor patterns 123 neighboring in the third direction D3, between an uppermost semiconductor pattern 123 and the first mask layer 140, and between a lowermost semiconductor pattern 123 and the substrate 100.

The second mask 320 may be formed of or include an insulating nitride, e.g., silicon nitride, and the first mask layer 140 and the first mask 145 may be merged with the second mask 320. Hereinafter, the merged structure may be referred to as the second mask 320.

An eighth division layer may be formed on the substrate 100 and the second mask 320 to fill the second gaps and the sixth openings 330, and a planarization process may be performed on the eighth division layer until an upper surface of the second mask 320 is exposed to form an eighth division pattern 340 in the second gaps and the sixth openings 330. The eighth division pattern 340 may be formed of or include an insulating nitride, e.g., silicon nitride, and thus, in some embodiments, the support patterns 210 may be merged with the eighth division pattern 340.

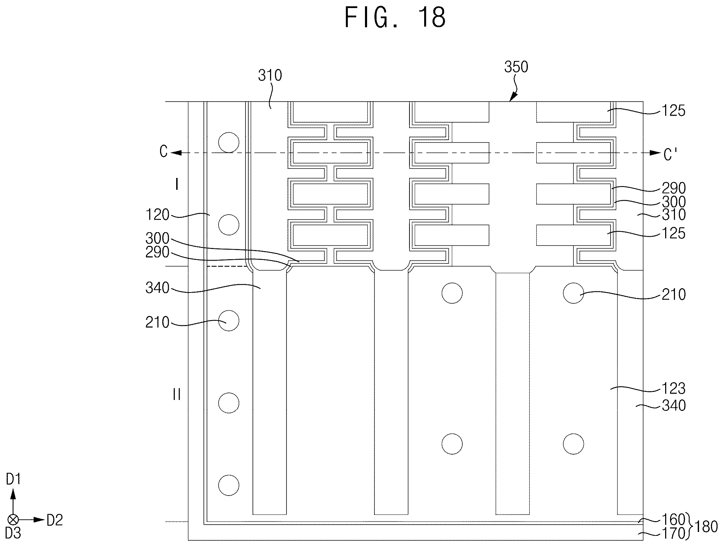

Referring to FIGS. 18 to 20, the second mask 320 and the third division structure may be partially removed by, e.g., a dry etching process to form a seventh opening 350 exposing the upper surface of the substrate 100.

For example, a wet etching process may be performed through the seventh opening 350, and portions of the third division structure that are adjacent to the seventh opening 350 and disposed between the channels 125 neighboring each other in the third direction D3 may be removed to form third gaps. Accordingly, upper and lower surfaces and sidewalls of the first end portions in the second direction D2 of the channels 125 and sidewalls of the third division structure may be exposed.

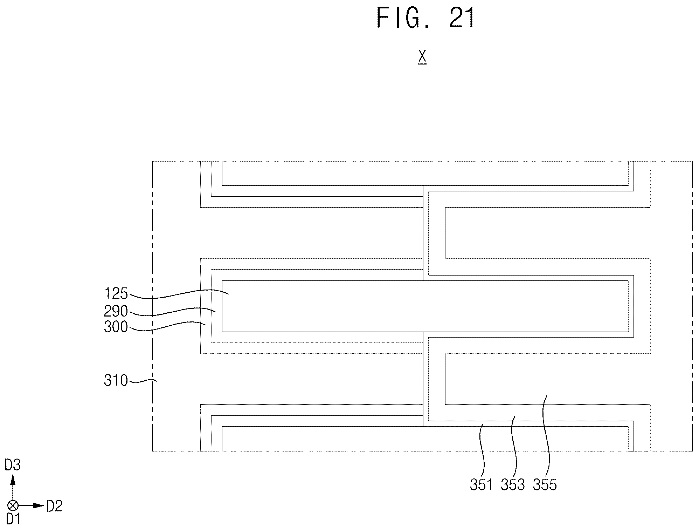

Referring to FIG. 21, a first buried layer 351 may be formed on the upper surface of the substrate 100, the upper and lower surfaces and the sidewalls of the first end portions in the second direction D2 of the channels 125 and the sidewalls of the third division structure exposed by the seventh opening 350 and the third gaps, and a sidewall and the upper surface of the first mask 145. The first buried layer 351 may be formed of or include an oxide, for example, silicon oxide.

Subsequently, second and third buried layers 353 and 355 may be sequentially formed on the first buried layer 351. The third buried layer 355 may be formed to fill spaces between the first end portions of the channels 125 neighboring each other in the first direction D1. The second buried layer 353 may be formed of or include a nitride, for example, silicon nitride. The third buried layer 355 may be formed of or include an oxide, for example, silicon oxide.

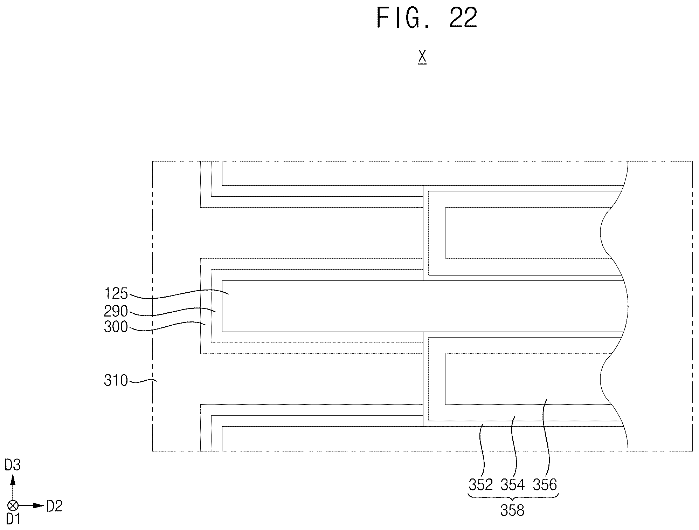

Referring to FIG. 22, portions of the first to third buried layers 351, 353, and 355 excluding portions of the first to third buried layers 351, 353, and 355 within the third gaps may be removed. Accordingly, the first buried layer 351 may be converted into first buried patterns 352 covering the upper surface of the substrate 100, the upper and lower surfaces and the sidewalls of the first end portions in the second direction D2 of the channels 125, and the sidewalls of the third division structure. The second buried layer 353 may be converted into second buried patterns 354 extending in the first direction D1 while surrounding the first end portions in the second direction D2 of the channels 125. The third buried layer 355 may be converted into third buried patterns 356 extending in the first direction D1 between the second buried patterns 354 neighboring each other in the third direction D3.

The first to third buried patterns 352, 354, and 356 may collectively form a buried structure 358.

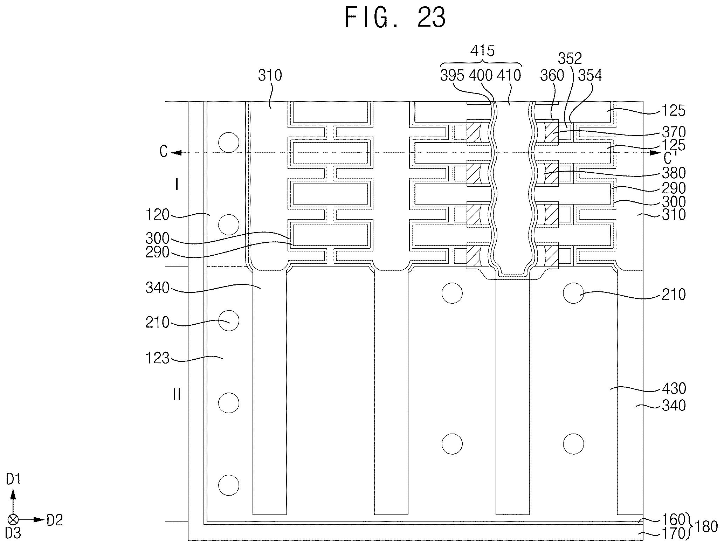

Referring to FIGS. 23 to 25, the second buried patterns 354 may be partially removed. Accordingly, fourth gaps may be formed to expose the first buried patterns 352 covering the upper and lower surfaces and the sidewalls of the first end portions in the second direction D2 of the channels 125. In example embodiments, corresponding to the second buried patterns 354, the fourth gaps may be formed to extend in the first direction D1 while surrounding the first end portions in the second direction D2 of the channels 125.

Subsequently, portions of the first buried patterns 352 exposed by the fourth gaps may be removed. Accordingly, the upper and lower surfaces and the sidewalls of the first end portions in the second direction D2 of the channels 125 may be at least partially exposed. Meanwhile, the third buried patterns 356 exposed by the fourth gaps may also be partially removed together with the first buried patterns 352.

For example, a thermal oxidation process may be performed to form gate insulation patterns 360 covering the upper surface of the substrate 100 and the upper and lower surfaces and the sidewalls of the first end portions of the channels 125 exposed by the seventh openings 350 and the fourth gaps.

Subsequently, a gate electrode layer may be respectively formed to fill the fourth gaps, and an etch-back process may be performed on the gate electrode layer to form gate electrodes 370 that may partially surround the gate insulation patterns 360.

The gate electrodes 370 may be partially removed through the seventh opening 350 to form first recesses. Subsequently, gate masks 380 may be respectively formed within the first recesses to partially surround the gate insulation patterns 360. The gate masks 380 may contact sidewalls in the second direction D2 of the gate electrodes 370.

The gate electrodes 370, the gate insulation patterns 360, and the gate masks 380 may collectively form gate structures. Each of the gate electrodes 370 may extend in the first direction D1 to surround the first end portions in the second direction D2 of the channels 125 in the first region I of the substrate 100. Thus, the gate structures may be disposed in the third direction D3 at each of opposite sides in the second direction D2 of the seventh opening 350. Each of the gate structures may serve as a word line of the semiconductor device.

Subsequently, a third insulation layer and a fourth insulation layer may be sequentially stacked on sidewalls in the second direction D2 of the gate structures adjacent to the seventh opening 350, sidewalls in the second direction D2 of the third buried patterns 356, and a bottom of the seventh opening 350, and a ninth division layer may be formed to fill a remaining portion of the seventh opening 350. Subsequently, a planarization process may be performed on the third and fourth insulation layers and the ninth division layer until the upper surface of the second mask 320 is exposed to form a third insulation pattern 395, a fourth insulation pattern 400, and a ninth division pattern 410, respectively.

The third insulation pattern 395 and the ninth division pattern 410 may be formed of or include an oxide, for example, silicon oxide, and the fourth insulation pattern 400 may be formed of or include an insulating nitride, for example, silicon nitride.

Meanwhile, the third and fourth insulation patterns 395 and 400 and the ninth division pattern 410 may together form a fourth division structure 415.

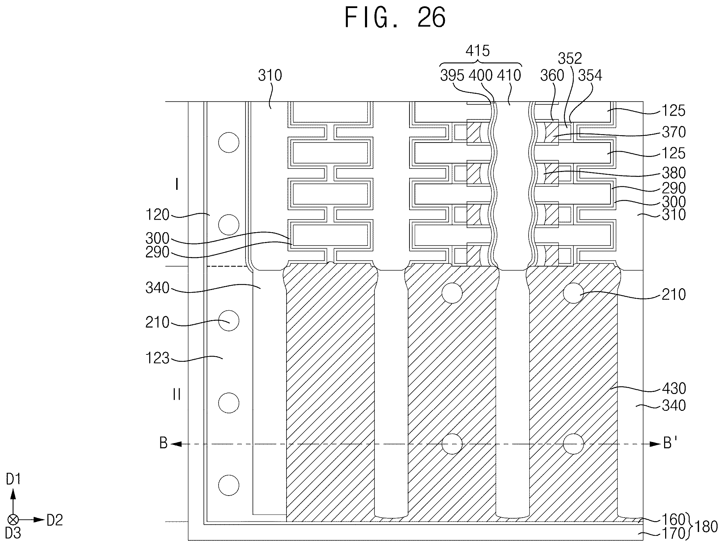

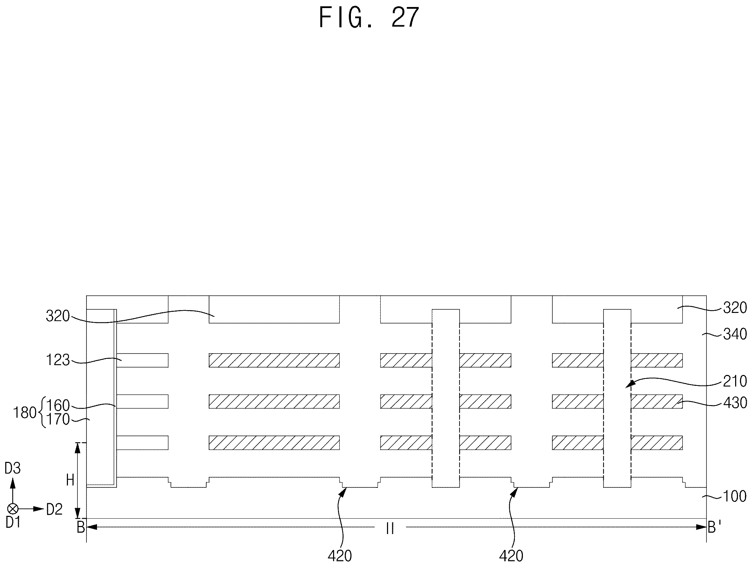

Referring to FIGS. 26 and 27, the eighth division pattern 340 may be removed by, e.g., a dry etching process to form eighth openings 420 exposing the upper surface of the substrate 100, and e.g., a wet etching process may be performed through the eighth openings 420 to remove the semiconductor patterns 123 to form fifth gaps, a conductive pad layer may be formed to fill the fifth gaps, and for example, a wet etching process may be performed on the conductive pad layer to form conductive pads 430 in the fifth gaps.

In example embodiments, the conductive pads 430 may extend in the first direction D1 in the second region II of the substrate 100, and may be spaced apart from each other in the second direction D2. Additionally, the conductive pads 430 may be spaced apart from each other in the third direction D3.

A tenth division layer may be formed to fill the eighth openings 420, and a planarization process may be performed on the tenth division layer until the upper surface of the second mask 320 is exposed to form tenth division patterns in the eighth openings 420. The tenth division patterns may be formed of or include an insulating nitride, e.g., silicon nitride, and may contact horizontal portions of the eighth division pattern 340 between the conductive pads 430 spaced apart from each other in the third direction D3 to be merged thereto. Hereinafter, the horizontal portions of the eighth division pattern 340 together with the tenth division patterns merged thereto may be referred to as the eighth division pattern 340.

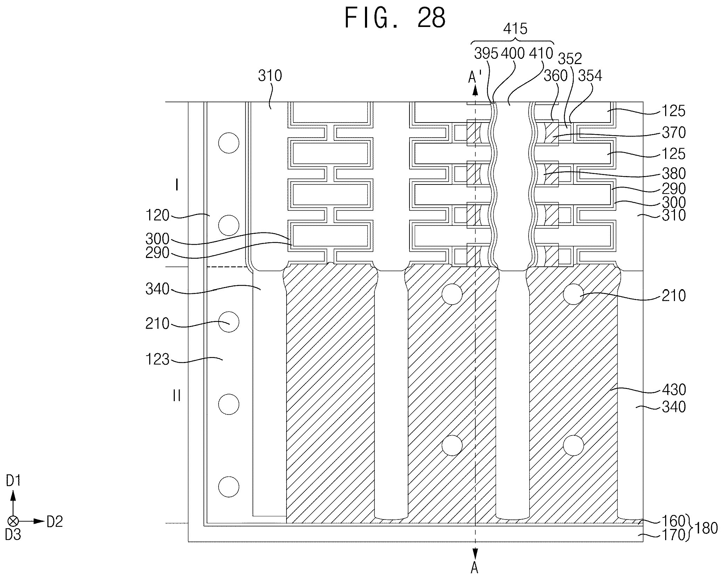

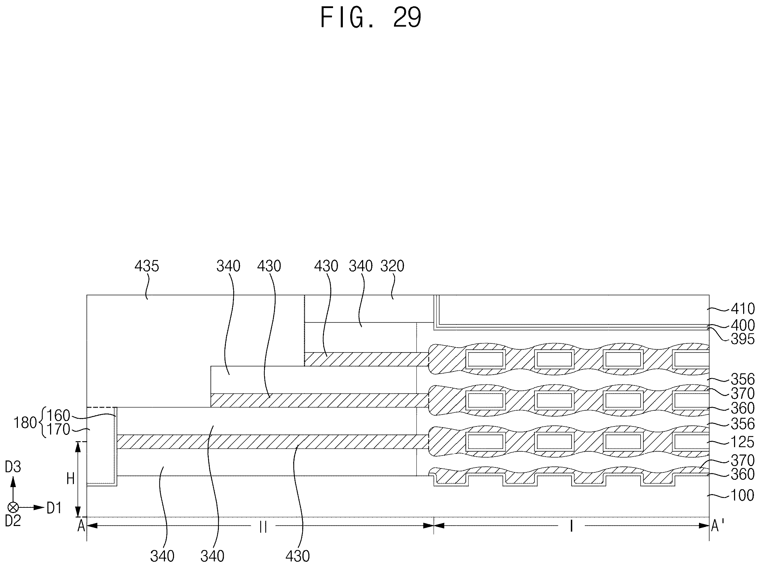

Referring to FIGS. 28 and 29, the second mask 320, the eighth division pattern 340, and the conductive pads 430 in the second region II may be partially removed by, e.g., a dry etching process to form a ninth opening exposing an upper surface of the eighth division pattern 340.

In example embodiments, after the dry etching process, each of the conductive pads 430 and a portion of the eighth division pattern 340 thereon may collectively form a step layer extending in the first direction D1, and a stack structure including the conductive pads 430 and the eighth division pattern 340 may have a staircase structure having a length decreasing from a bottom toward a top thereof in a stepwise manner. During the dry etching process, upper portions of the first and second division patterns 160 and 170 contacting end portions in the first direction D1 of the conductive pads 430 may also be removed.

A second insulating interlayer 435 may be formed to fill the ninth opening. The second insulating interlayer 435 may be formed of or include an oxide, e.g., silicon oxide, and in some embodiments, may be merged with the second division pattern 170.

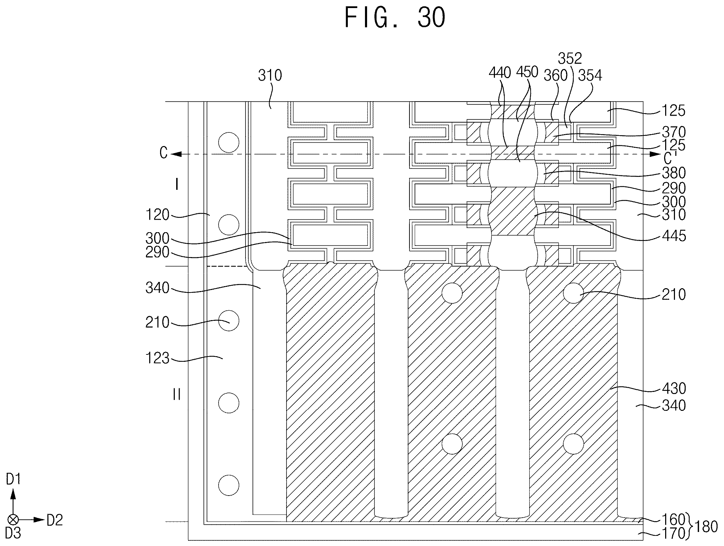

Referring to FIGS. 30 to 32, the fourth division structure 415 may be partially etched by, e.g., a dry etching process on the memory cell region of the substrate 100 to form a first trench, a bit line layer may be formed in the first trench, and the bit line layer may be patterned to form bit lines 440.

As the first trench is formed, end portions in the second direction D2 of the channels 125, the gate insulation patterns 360 and the gate masks 380 that are disposed in the third direction D3 at each of opposite sides in the second direction D2 of the fourth division structure 415 may be exposed, and thus, the bit lines 440 extending in the third direction D3 in the first trench may contact the end portions in the second direction D2 of the channels 125, the gate insulation patterns 360, and the gate masks 380.

In example embodiments, the bit lines 440 may be spaced apart from each other in the first direction D1 in the first region I of the substrate 100, and the bit lines 440 may respectively contact the channels 125 disposed in the first direction D1 to be electrically connected thereto. However, one of the bit lines 440 disposed in the first direction D1 that is adjacent to the second region II may be a dummy bit line 445. As used herein, the term "dummy" is used to refer to a component that has substantially the same structure and shape as other components but does not have a substantial function and exists only as a pattern in the device.

In an example embodiment, the bit lines 440 may be formed of or include polysilicon doped with n-type impurities. Alternatively, the bit lines 440 may be formed of or include, e.g., a metal, a metal nitride, a metal silicide, etc.

Meanwhile, first source/drain regions SDR1 may be formed in portions of the second end portions of the channels 125 that contact the bit lines 440 or the dummy bit line 445. The first source/drain regions SDR1 may further include, for example, n-type impurities or p-type impurities.

In an example embodiment, the first source/drain regions SDR1 may be formed by diffusion of n-type impurities or p-type impurities of the bit line layer to the first end portions of the channels 125. In another example embodiment, the first source/drain regions SDR1 may also be formed by performing, for example, a gas phase doping process on the first end portions of the channels 125 through the first trench. In yet another example embodiment, instead of forming the first source/drain regions SDR1, second recesses may be formed by partially removing the first end portions of the channels 125, and first source/drain layers may respectively be formed within the second recesses by performing, for example, an epitaxial growth process or a deposition process. The first source/drain layers may include a semiconductor material doped with n-type impurities or p-type impurities.

Eleventh division patterns 450 filling spaces between the bit lines 440 disposed in the first direction D1 may be formed on the memory cell region of the substrate 100. The eleventh division patterns 450 may be formed of or include an oxide, e.g., silicon oxide.

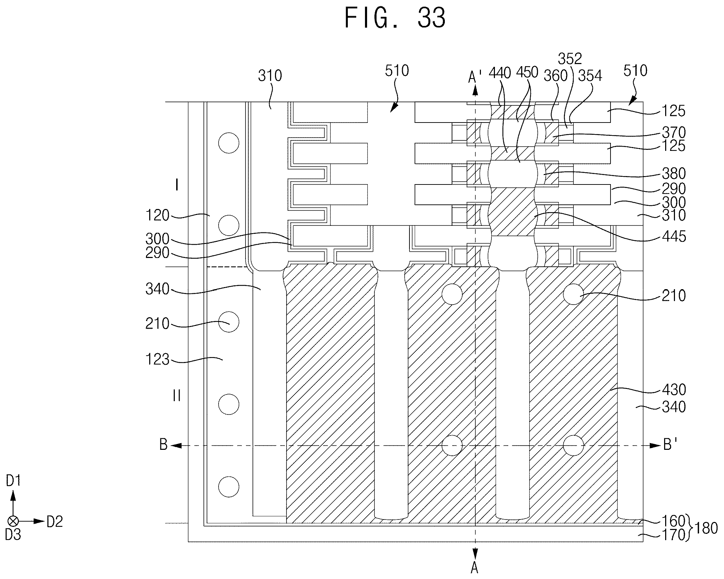

Referring to FIGS. 33 to 35, a capping layer 500 may be formed on the bit lines 440, the dummy bit line 445, the second insulating interlayer 435, the second mask 320, the seventh division pattern 310, the fourth division structure 415 and the eleventh division patterns 450. The capping layer 500 may be formed of or include an insulating nitride, e.g., silicon nitride.

The capping layer 500, the second mask 320, and the third division structure may be partially removed by, e.g., a dry etching process to form eleventh openings 510 exposing the upper surface of the substrate 100.

Subsequently, sixth gaps may be formed by removing portions of the third division structure between the channels 125 neighboring each other in the third direction D3 by, for example, a wet etching process through the eleventh openings 510. The buried structure 358 may be also partially removed. Accordingly, upper and lower surfaces and sidewalls of second end portions in the second direction D2 of the channels 125, and sidewalls in the second direction D2 of the first and second buried patterns 352 and 354 may be exposed by the eleventh openings 510 and the sixth gaps.

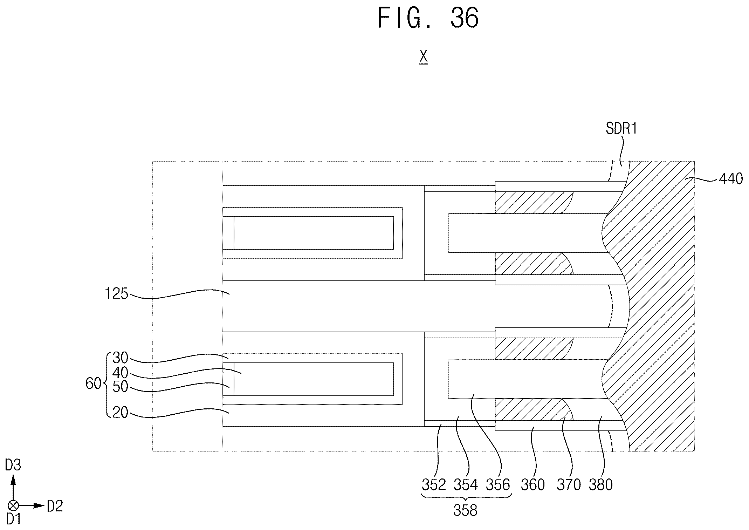

Referring to FIG. 36, a second sacrificial mold layer 20 may be formed on the exposed upper surface of substrate 100, the upper and lower surfaces and the sidewalls of the second end portions of the channels 125, the sidewalls in the second direction D2 of the first and second buried patterns 352 and 354, the sidewalls of the third division structure, the sidewall of the second mask 320, and the sidewall and an upper surface of the capping layer 500. The second sacrificial mold layer 20 may be formed of or include an oxide, for example, silicon oxide.

Third and fourth sacrificial mold layers 30 and 40 may be sequentially formed on an inner wall of the second sacrificial mold layer 20. The fourth sacrificial mold layer 40 may be formed to fill remaining portions of the sixth gaps. The third sacrificial mold layer 30 may be formed of or include a nitride, for example, silicon nitride. The fourth sacrificial mold layer 40 may be formed of or include an oxide, for example, silicon oxide.

Portions of the second to fourth sacrificial mold layers 20, 30, and 40 except for portions of the second to fourth sacrificial mold layers 20, 30, and 40 formed within the sixth gaps may be removed. Accordingly, the second to fourth sacrificial mold layers 20, 30, and 40 may be divided into a plurality of second sacrificial mold layers 20, a plurality of third sacrificial mold layers 30, and a plurality of fourth sacrificial mold layers 40, respectively.

Third recesses may be formed by partially removing the fourth sacrificial mold layers 40 through the eleventh openings 510. Subsequently, the fifth sacrificial mold layers 50 filling the third recesses may be formed. The fifth sacrificial mold layers 50 may be formed of or include a nitride, for example, silicon nitride. Accordingly, the third and fifth sacrificial mold layers 30 and 50 may be merged with each other.

In example embodiments, the third and fifth sacrificial mold layers 30 and 50 may be formed to surround the fourth sacrificial mold layers 40. That is, the fourth sacrificial mold layers 40 may be formed within spaces defined by the third sacrificial mold layers 30 and the fifth sacrificial mold layers 50.

The second to fifth sacrificial mold layers 20, 30, 40, and 50 may together form the sacrificial mold layer structures 60. The sacrificial mold layer structures 60 may be formed to fill spaces between the second end portions of the channels 125.

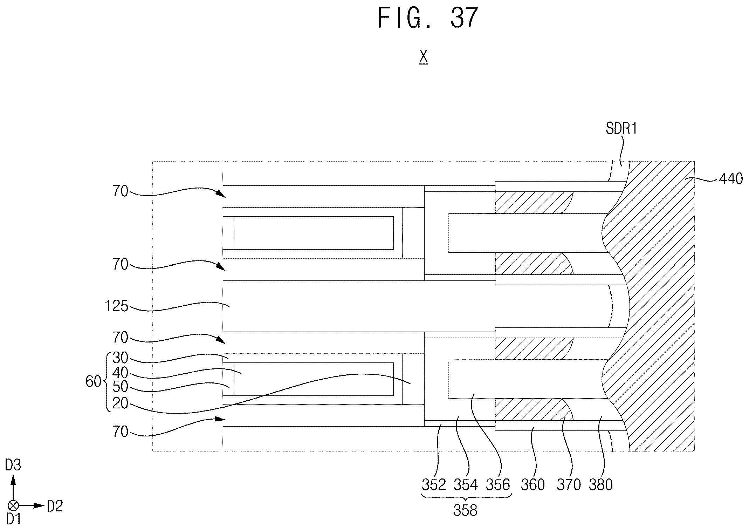

Referring to FIG. 37, the second sacrificial mold layers 20 may be partially removed through the eleventh openings 510. Accordingly, the second sacrificial mold layers 20 may remain between the third sacrificial mold layers 30 and the buried structure 358. In example embodiments, the second sacrificial mold layers 20 may be partially removed by, for example, a wet etching process.

Seventh gaps 70 may be respectively formed between the sacrificial mold layer structures 60 and the second end portions of the channels 125 by partially removing the second sacrificial mold layers 20. The seventh gaps 70 may reopen the upper and lower surfaces and the sidewalls of the second end portions of the channels 125 and the sidewalls in the second direction D2 of the buried structure 358.

In example embodiments, a cross-section of each the seventh gaps 70 in a plane determined by first and third directions D1 and D3 may have, for example, a rectangular ring shape.

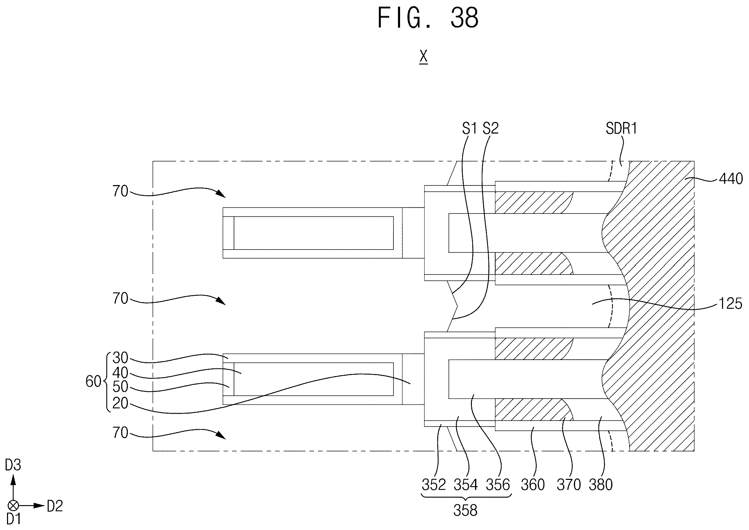

Referring to FIGS. 38 and 39, an etching process may be performed on the second end portions of the channels 125 exposed by the seventh gaps 70. As a result of the etching process, a sidewall in the second direction D2 of the channel 125 may be recessed inwardly relative to the sidewall in the second direction D2 of the buried structure 358.

The etching process may be a sigma etch process. A sigma etch process may be a process for forming a sigma (Σ) shaped trench. A sigma etch process may include performing an anisotropic (e.g. a wet) etching process to create a Σ-shaped trench. A dry etching process may be performed prior to the anisotropic etching process. The resulting trench may be widest in its middle and may taper towards the top and bottom. Accordingly, a first sidewall S1, which is an upper sidewall in the second direction D2 of the second end portion of the channel 125, and a second sidewall S2, which is a lower sidewall in the second direction D2 of the second end portion of the channel 125, may have slopes inclined in opposite directions with respect to the upper surface of the substrate 100.

In example embodiments, due to the etching process, the seventh gaps 70 may be expanded, and a cross-section of each of the seventh gaps 70 in a plane determined by first and third directions D1 and D3 may be formed to have, for example, a rectangular shape.

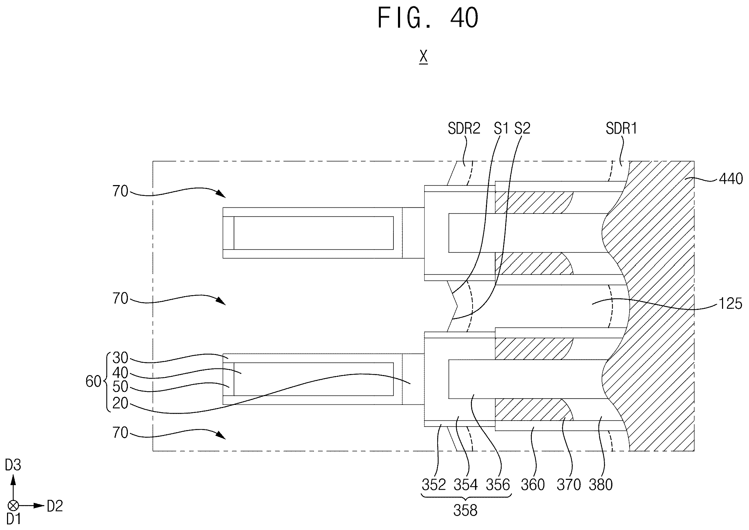

Referring to FIG. 40, second source/drain regions SDR2 may be formed by performing, for example, a gas phase doping process on the second end portions of the channels 125 exposed by the seventh gaps 70. The second source/drain regions SDR2 may further include, for example, n-type impurities or p-type impurities.

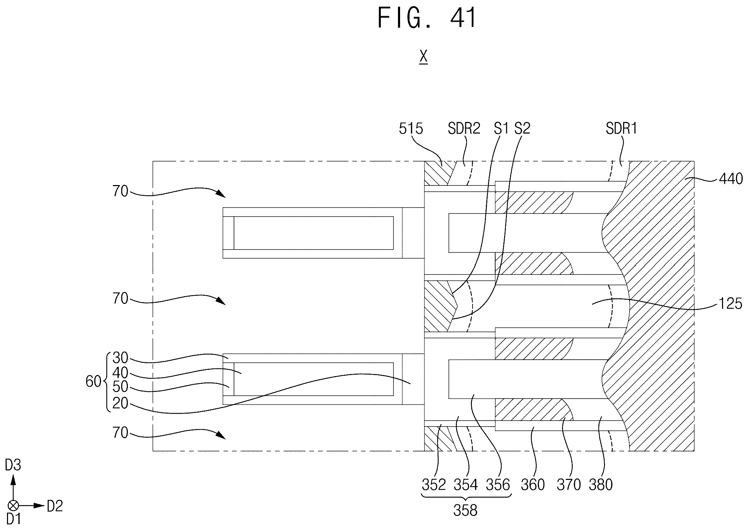

Referring to FIGS. 41 to 42, ohmic contacts 515 may be formed on sidewalls in the second direction D2 of the second end portions of the channels 135 within the seventh gaps 70. The ohmic contacts 515 may be formed of or include a silicide, for example, tungsten silicide, molybdenum silicide, titanium silicide, cobalt silicide, nickel silicide, platinum silicide, etc.

In example embodiments, the ohmic contacts 515 may be formed by forming an ohmic contact layer to fill the seventh gaps 70, and performing, for example, an etch-back process on the ohmic contact layer.

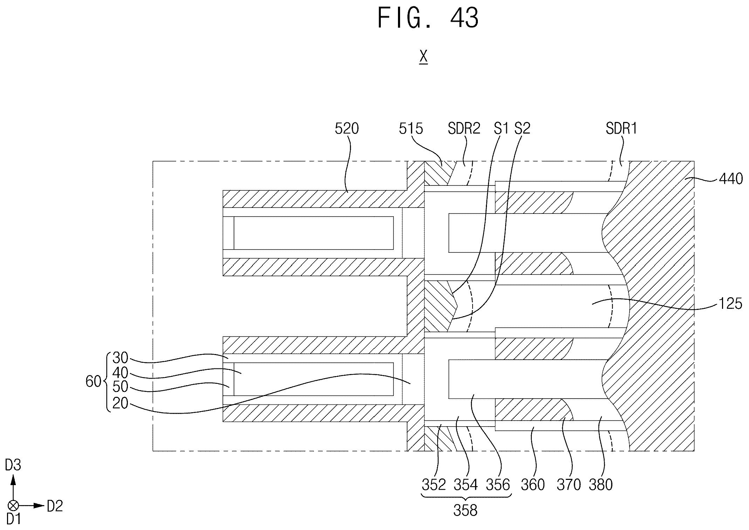

Referring to FIG. 43, the first capacitor electrodes 520 may be formed along inner walls of the seventh gaps 70.

The first capacitor electrodes 520 may be respectively formed in the seventh gaps 70 which are formed by removing the second end portions of the channels 125 and the second sacrificial mold layers 20. Accordingly, compared to when the seventh gaps 70 are formed by removing only the second end portions of the channels 125, the first capacitor electrodes 520 may be formed with larger surface areas.

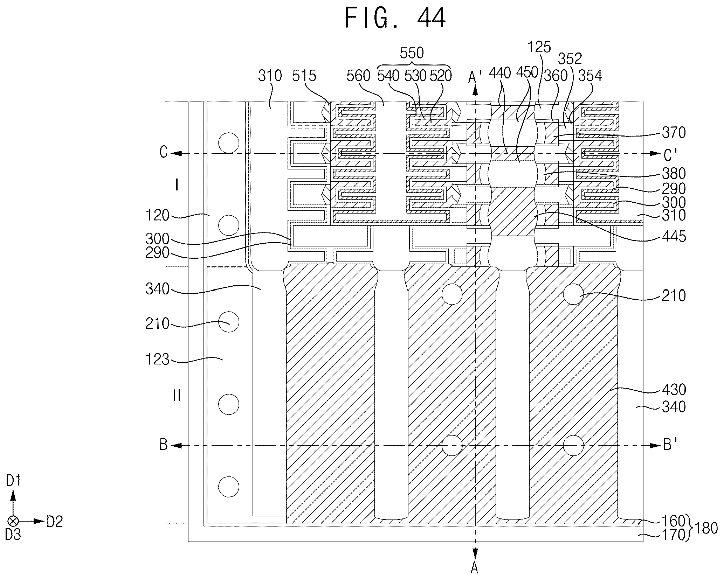

Referring to FIGS. 44 to 46, the sacrificial mold layer structures 60 may be removed. Accordingly, eighth gaps may be formed between the first capacitor electrodes 520. The eighth gaps may expose portions of the sidewalls in the second direction D2 of the buried structure 358, surfaces of the first capacitor electrodes 520, and the sidewalls of the third division structure.

Subsequently, a dielectric layer and a second capacitor electrode layer may be sequentially stacked on the exposed portions of the sidewalls in the second direction D2 of the buried structure 358, the surfaces of the first capacitor electrodes 520, the sidewalls of the third division structure, a sidewall of the second mask 320, and the sidewall and the upper surface of the capping layer 500. Subsequently, a plate electrode layer may be formed to fill the eighth gaps and the eleventh openings 510 on the second capacitor electrode layer, and the plate electrode layer, the second capacitor electrode layer and the dielectric layer may be planarized until the upper surface of the capping layer 500 is exposed to form second capacitor electrodes 540, dielectric patterns 530 and plate electrodes 560, respectively.

The first and second capacitor electrodes 520 and 540 and the dielectric patterns 530 may together form capacitors 550, and the capacitors 550 and the plate electrodes 560 may together form capacitor structures.

Referring back to FIGS. 1 to 6, a third insulating interlayer layer 600 may be formed on the capacitor structures and the capping layer 500. First contact plugs 612 may be formed to respectively contact upper surfaces of the bit lines 440 by extending through the third insulating interlayer layer 600 and the capping layer 500. Second contact plugs 614 may be formed to respectively contact upper surfaces of the capacitor structures by extending through the third insulating interlayer layer 600. Third contact plugs 616 may be formed to respectively contact upper surfaces of the conductive pads 430 by extending through the third insulating interlayer layer 600, the capping layer 500, the second mask 320 and the eighth division pattern 340 or through the third insulating interlayer layer 600, the capping layer 500 and the second insulating interlayer layer 435.

By performing the above processes, the manufacture of the semiconductor device may be completed.

In a method for manufacturing a semiconductor device, the sigma etch process may be performed on the second end portions of the channels 125 so that the sidewalls of the second end portions of the channels 125 may be formed to have a wider surface area. Accordingly, contact surfaces between the channels 125 and the ohmic contacts 515 may increase, thereby reducing contact resistance.

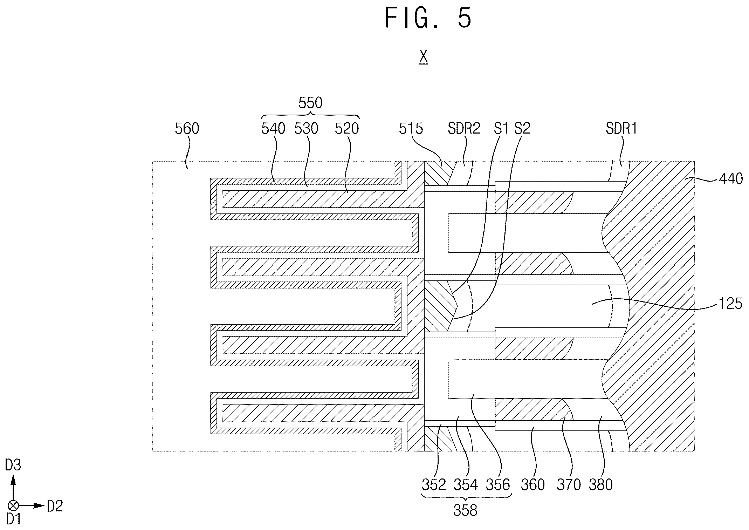

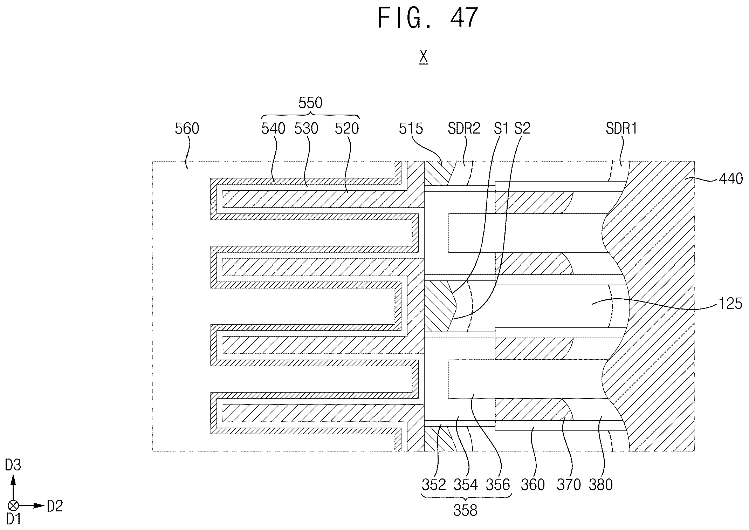

FIG. 47 is a vertical cross-sectional view illustrating a semiconductor device according to example embodiments, corresponding to FIG. 5. The semiconductor device is substantially the same as that described with reference to FIGS. 1 to 6, except for shape of the channels 125 and shape of the ohmic contacts 515, and thus, repeated explanations are omitted herein.

Referring to FIG. 47, the vertex where the first and second sidewalls S1 and S2 meet may be rounded. Correspondingly, a cross-section of the ohmic contact 515 determined by a plane defined by the second and third directions D2 and D3 may have a pentagonal shape with a rounded vertex facing the channel 125.

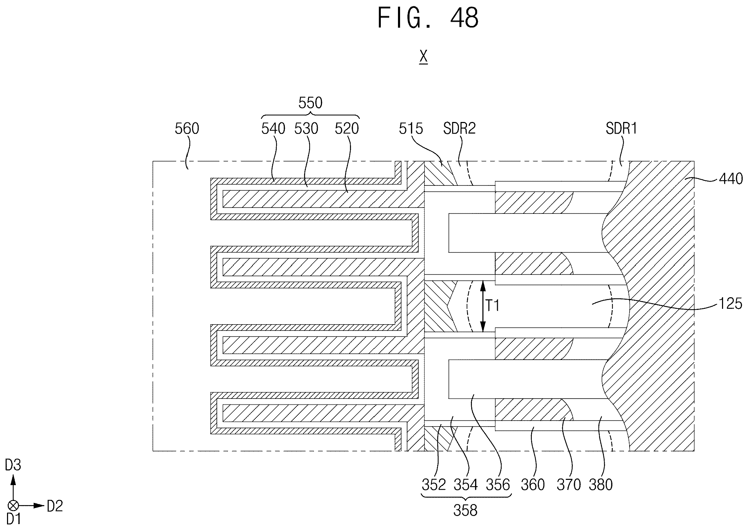

FIG. 48 is a vertical cross-sectional view illustrating a semiconductor device according to example embodiments, corresponding to FIG. 5. The semiconductor device is substantially the same as that described with reference to FIG. 1 to 6, except for a shape of the channels 125 and a shape of the ohmic contacts 515, and thus, repeated explanations are omitted herein.

Referring to FIG. 48, the sidewall in the second direction D2 of the second end portion of the channel 125 may have a convex shape. In example embodiments, in a cross-section of the channel 125 determined by a plane defined by the second and third directions D2 and D3, the first and second sidewalls S1 and S2 may converge to form a V-shaped configuration, with a vertex formed by the first and second S1 and S2 being oriented toward an exterior of the channel.

In example embodiments, corresponding to a profile of the sidewall in the second direction D2 of the second end portion of the channel 125, a cross-section of the ohmic contact 515 determined by a plane defined by the second and third directions D2 and D3 may have a concave pentagonal shape with sides facing the channel 125 concavely arranged. In example embodiments, an upper sidewall and a lower sidewall of the ohmic contact 515 in the second direction D2 that respectively contact the first and second sidewalls S1 and S2 of the channel 125 may face each other in the third direction D3.

In example embodiments, a first thickness T1 in the third direction D3 of the second end portion of the channel 125 may be constant along the second direction D2 and then gradually decrease when approaching the capacitors 550.

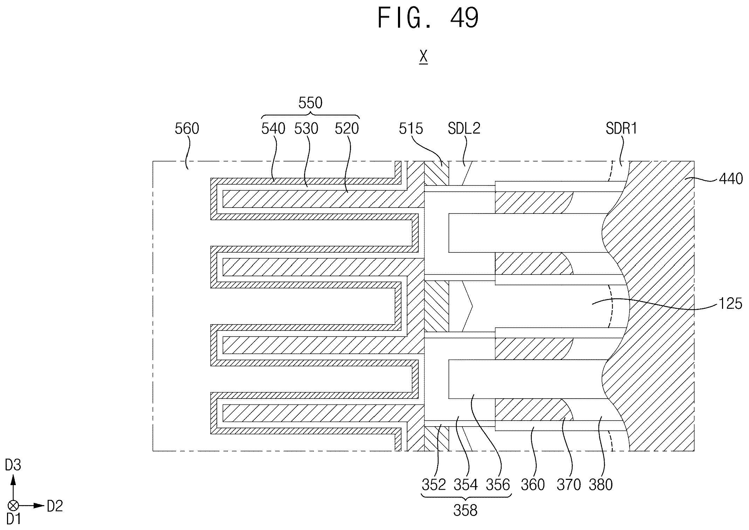

FIG. 49 is a vertical cross-sectional view illustrating a semiconductor device according to example embodiments, corresponding to FIG. 5. The semiconductor device is substantially the same as that described with reference to FIGS. 1 to 6, except for including second source/drain layers SDL2 instead of the second source/drain regions SDR2, and shape of the ohmic contacts 515, and thus, repeated explanations are omitted herein.

Referring to FIG. 49, instead of portions of the second end portions of the channels 125 facing the capacitors 550 forming the second source/drain regions SDR2, the second source/drain layers SDL2 may be disposed as separate structures on the sidewalls in the second direction D2 of the second ends of the channels 125. This may be formed by forming the second source/drain regions SDR2 on the sidewalls in the second direction D2 of the second ends of the channels 125 after the sigma etch process has been performed. The second source/drain layers SDL2 may include semiconductor material doped with n-type impurity or p-type impurity.

In example embodiments, a cross-section of a second source/drain layer SDL2 determined by a plane defined by the second and third directions D2 and D3 may have a pentagonal shape. In example embodiments, the second source/drain layer SDL2 may have a pentagonal column shape extending lengthwise in the first direction D1.

In example embodiments, a cross-section of the ohmic contact 515 determined by a plane defined by the second and third directions D2 and D3 may have a rectangular shape. In example embodiments, the ohmic contact 515 may have a rectangular column shape extending in the first direction D1.

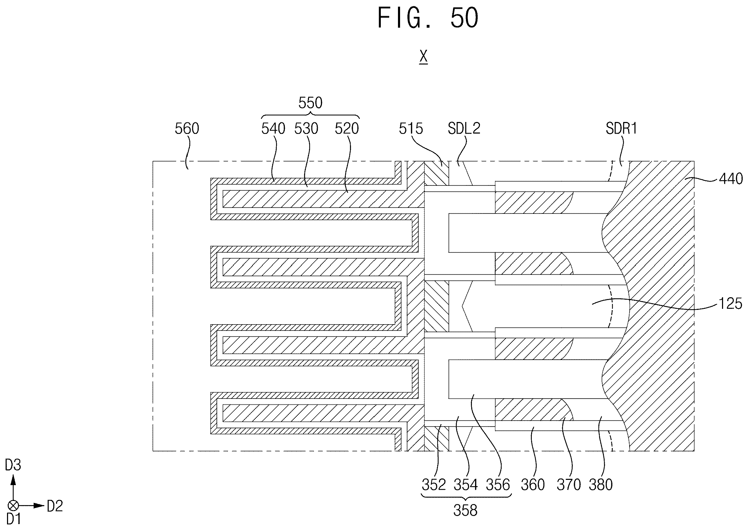

FIG. 50 is a vertical cross-sectional view illustrating a semiconductor device according to example embodiments, corresponding to FIG. 49. The semiconductor device is substantially the same as that described with reference to FIG. 49, except for shape of the channels 125 and shape of the second source/drain layers SDL2, and thus, repeated explanations are omitted herein.

Referring to FIG. 50, the sidewall in the second direction D2 of the second end portion of the channel 125 may have a convex shape. In example embodiments, in a cross-section of the channel 125 determined by a plane defined by the second and third directions D2 and D3, the first and second sidewalls S1 and S2 may converge to form a V-shaped configuration, with a vertex formed by the first and second sidewalls S1 and S2 being oriented toward an exterior of the channel 125.

In example embodiments, corresponding to a profile of the sidewall in the second direction D2 of the second end portion of the channel 125, a cross-section of the second source/drain layer SDL2 determined by a plane defined by the second and third directions D2 and D3 may have a concave pentagonal shape with sides facing the channel 125 concavely arranged. In example embodiments, an upper sidewall and a lower sidewall in the second direction D2 of the second source/drain layer SDL2 that respectively contact the first and second sidewalls S1 and S2 of the channel 125 may face each other in the third direction D3. This may be formed by forming the second source/drain regions SDR2 on the sidewalls in the second direction D2 of the second ends of the channels 125 after the channel 125 has been etched to form the first and second sidewalls S1 and S2 having a V-shaped configuration, with a vertex formed by the first and second sidewalls S1 and S2 being oriented toward an exterior of the channel 125.

In example embodiments, the first thickness T1 in the third direction D3 of the second end portion of the channel 125 may be constant along the second direction D2 and then gradually decrease when approaching the capacitors 550.

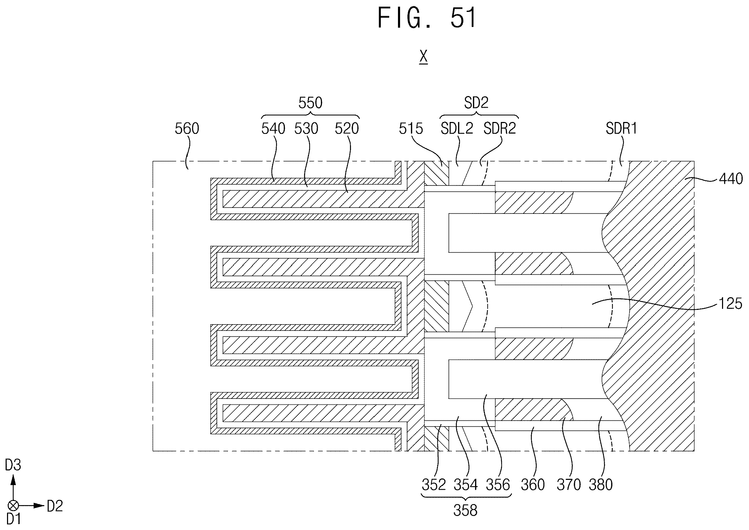

FIG. 51 is a vertical cross-sectional view illustrating a semiconductor device according to example embodiments, corresponding to FIG. 49. The semiconductor device is substantially the same as that described with reference to FIG. 49, except for further including second source/drain regions SDR2, and thus, repeated explanations are omitted herein.

Referring to FIG. 51, the second source/drain regions SDR2 may form second source/drain structures SD2 together with the second source/drain layers SDL2. The second source/drain regions SDR2 may be formed in the portions of the second end portions of the channels 125 facing the capacitors 550. The second source/drain layers SDL2 may be disposed on the sidewalls in the second direction D2 of the second end portions of the channels 125.

Although the drawing shows that a cross-section of a second source/drain layer SDL2 determined by a plane defined by the second and third directions D2 and D3 has a pentagonal shape, the inventive concepts are not limited thereto. That is, a cross-section of the second source/drain layer SDL2 determined by a plane defined by the second and third directions D2 and D3 may also have a concave pentagonal shape with sides facing the channel 125 concavely arranged, similar to the second source/drain layers SDL2 of FIG. 50.

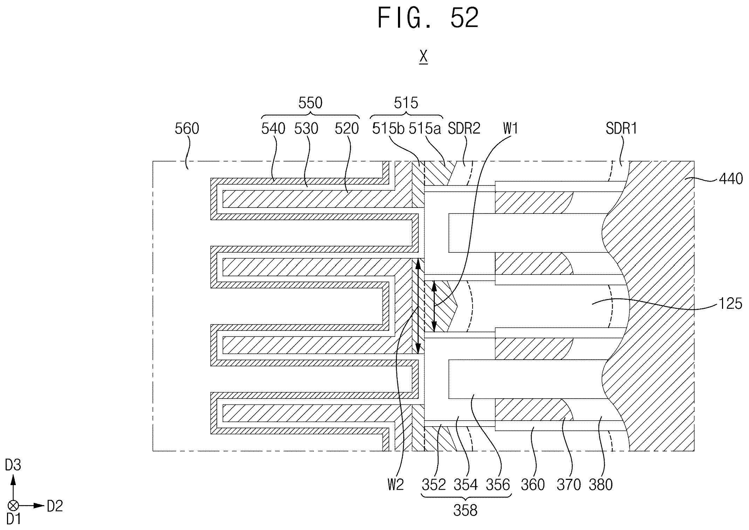

FIG. 52 is a vertical cross-sectional view illustrating a semiconductor device according to example embodiments, corresponding to FIG. 5. The semiconductor device is substantially the same as that described with reference to FIGS. 1 to 6, except for the ohmic contact 515, and thus, repeated explanations are omitted herein.

Referring to FIG. 52, the ohmic contact 515 may include first and second portions 515a and 515b sequentially stacked in the second direction D2 on the second end portion of the channel 125. The first portion 515a of the ohmic contact 515 may overlap with the buried structure 358 in the third direction D3, and the second portion 515b of the ohmic contact 515 may protrude in the second direction D2 from the sidewall in the second direction D2 of the buried structure 358.

In example embodiments, the first portion 515a of the ohmic contact 515 may have a first width W1 in the third direction D3, and the second portion 515b of the ohmic contact 515 may have a second width W2 in the third direction D3. In example embodiments, the second width W2 may be greater than the first width W1.

In example embodiments, a cross-section of the first portion 515a of the ohmic contact 515 determined by a plane defined by the first and third directions D1 and D3 may have a first area, and a cross-section of the second portion 515b of the ohmic contact 515 determined by the first and third directions D1 and D3 may have a second area. In example embodiments, the second area may be greater than the first area.

Although the drawing shows that a cross-section of the first portion 515a of the ohmic contact 515 determined by a plane defined by the second and third directions D2 and D3 has a pentagonal shape, the inventive concepts are not limited thereto. That is, a cross-section of the first portion 515a of the ohmic contact 515 determined by a plane defined by the second and third directions D2 and D3 may also have a concave pentagonal shape with sides facing the channel 125 concavely arranged, similar to the ohmic contacts 515 of FIG. 48.

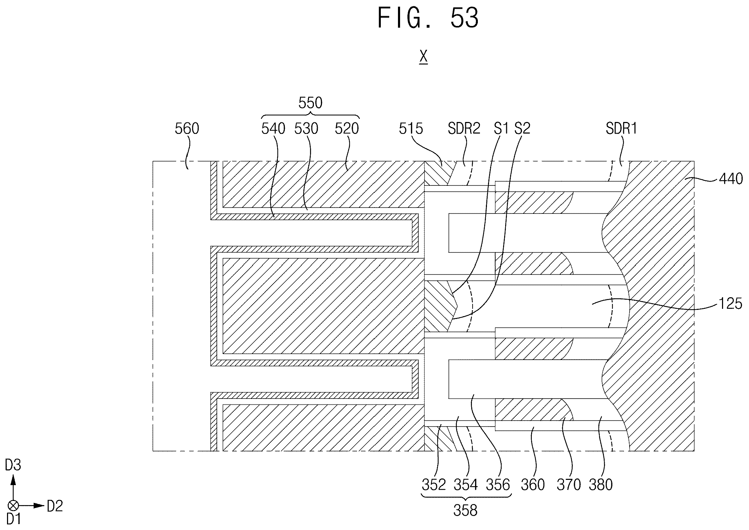

Meanwhile, the ohmic contact 515 of the semiconductor device of each of the aforementioned FIGS. 47 to 50 and the later described FIG. 53 may also include the first and second portions 515a and 515b sequentially stacked in the second direction D2 on the sidewall of the source/drain region SDR2 or the second source/drain layer SDL2.

FIG. 53 is a vertical cross-sectional view illustrating a semiconductor device according to example embodiments, corresponding to FIG. 5. The semiconductor device is substantially the same as that described with reference to FIGS. 1 to 6, except for shape of first capacitor electrodes 520, and thus, repeated explanations are omitted herein.

Referring to FIG. 53, the first capacitor electrode 520 may have, for example, a rectangular column shape extending in the second direction D2 from the sidewall in the second direction D2 of the ohmic contact 515.

Embodiments are set out in the following Clauses:
Clause 1. A semiconductor device comprising:
   a channel disposed on a substrate and extending in a first direction substantially parallel to an upper surface of the substrate;
   a gate structure extending in a second direction substantially parallel to the upper surface of the substrate and crossing the first direction, wherein the gate structure surrounds at least a portion of a first end portion in the first direction of the channel;
   a bit line electrically connected to the channel and extending in a vertical direction substantially perpendicular to the upper surface of the substrate along a sidewall in the first direction of the first end portion of the channel; and
   a capacitor disposed at a sidewall in the first direction of a second end portion in the first direction of the channel,
   wherein a first thickness in the vertical direction of the second end portion of the channel remains constant along the first direction and then gradually decreases when approaching the capacitor.
Clause 2. The semiconductor device of Clause 1,
   wherein the sidewall in the first direction of the second end portion of the channel includes an upper sidewall and a lower sidewall, and
   wherein in a cross-section of the channel determined by a plane defined by the first direction and the vertical direction, the upper sidewall and the lower sidewall converge to form a V-shaped configuration, with a vertex formed by the upper sidewall and the lower sidewall being oriented toward an exterior of the channel.
Clause 3. The semiconductor device of Clause 1 or Clause 2, further comprising:
   an ohmic contact disposed between the sidewall in the first direction of the second end portion of the channel and the capacitor.
Clause 4. The semiconductor device of Clause 3, wherein a cross-section of the ohmic contact determined by a plane defined by the first direction and the vertical direction has a concave pentagonal shape with sides facing the channel concavely arranged.
Clause 5. The semiconductor device of Clause 1, further comprising:
   an ohmic contact including a first portion and a second portion sequentially stacked along the first direction between the sidewall in the first direction of the second end portion of the channel and the capacitor,
   wherein a cross-section of the first portion of the ohmic contact determined by a plane defined by the first direction and the vertical direction has a concave pentagonal shape with sides facing the channel concavely arranged, and
   wherein the first portion of the ohmic contact has a first width in the vertical direction, the second portion of the ohmic contact has a second width in the vertical direction, and the second width is greater than the first width.
Clause 6. The semiconductor device of Clause 1, further comprising:
   a source/drain layer and an ohmic contact sequentially stacked along the first direction between the sidewall in the first direction of the second end portion of the channel and the capacitor.
Clause 7. The semiconductor device of Clause 6, wherein a cross-section of the source/drain layer determined by a plane defined by the first direction and the vertical direction has a concave pentagonal shape with sides facing the channel concavely arranged.
Clause 8. The semiconductor device of Clause 6,
   wherein the ohmic contact includes a first portion and a second portion sequentially stacked along the first direction between a sidewall in the first direction of the source/drain layer and the capacitor, and
   wherein the first portion of the ohmic contact has a first width in the vertical direction, the second portion of the ohmic contact has a second width in the vertical direction, and the second width is greater than the first width.
Clause 9. A semiconductor device comprising:
   a buried structure on a substrate, the buried structure extending in a vertical direction substantially perpendicular to an upper surface of the substrate and in a first direction substantially parallel to the upper surface of the substrate;
   a channel extending in a second direction substantially parallel to the upper surface of the substrate and crossing the first direction, wherein the channel at least partially penetrates the buried structure;
   a gate structure extending in the first direction and surrounding at least a portion of a first end portion in the second direction of the channel;
   a bit line electrically connected to the channel and extending in the vertical direction along a sidewall in the second direction of the first end portion of the channel; and
   a capacitor disposed at a sidewall in the second direction of a second end portion of the channel, the second end portion of the channel being an end portion in the second direction of the channel facing the first end portion of the channel,
   wherein the sidewall in the second direction of the second end portion of the channel includes an upper sidewall and a lower sidewall, the upper sidewall and the lower sidewall having slopes inclined in opposite directions with respect to the upper surface of the substrate, and
   wherein a first distance in the second direction between the sidewall in the second direction of the second end portion of the channel and the capacitor is greater than a second distance in the second direction between a sidewall in the second direction of the buried structure and the capacitor.
Clause 10. The semiconductor device of Clause 9, further comprising:
   an ohmic contact disposed between the second end portion of the channel and the capacitor,
   wherein the ohmic contact at least partially overlaps with the buried structure in the vertical direction.
Clause 11. The semiconductor device of Clause 9 or Clause 10, wherein in a cross-section of the channel determined by a plane defined by the second direction and the vertical direction, the upper sidewall and the lower sidewall converge to form a V-shaped configuration, with a vertex formed by the upper sidewall and the lower sidewall being oriented toward an interior of the channel.
Clause 12. The semiconductor device of Clause 9 or Clause 10, wherein in a cross-section of the channel determined by a plane defined by the second direction and the vertical direction, the upper sidewall and the lower sidewall converge to form a V-shaped configuration, with a vertex formed by the upper sidewall and the lower sidewall being oriented toward an exterior of the channel.

While the inventive concept has been shown and described with reference to embodiments thereof, it will be apparent to those of ordinary skill in the art that various modifications in form and details may be made thereto without departing from the scope of the inventive concept as set forth by the following claims.

## Claims

1. A semiconductor device, comprising:
a channel (125) disposed on a substrate and extending in a first direction substantially parallel to an upper surface of the substrate;
a gate structure extending in a second direction substantially parallel to the upper surface of the substrate and crossing the first direction, wherein the gate structure surrounds at least a portion of a first end portion in the first direction of the channel (125);
a bit line (440) electrically connected to the channel (125) and extending in a vertical direction substantially perpendicular to the upper surface of the substrate along a sidewall in the first direction of the first end portion of the channel (125); and
a capacitor (550) disposed at a sidewall in the first direction of a second end portion of the channel (125), the second end portion of the channel being an end portion in the first direction of the channel (125) facing the first end portion of the channel (125),
wherein the sidewall in the first direction of the second end portion of the channel (125) includes an upper sidewall (S1) and a lower sidewall (S2), and
wherein in a cross-section of the channel (125) determined by a plane defined by the first direction and the vertical direction, the upper sidewall (S1) and the lower sidewall (S2) converge to form a V-shaped configuration, with a vertex formed by the upper sidewall (S1) and the lower sidewall (S2) being oriented toward an interior of the channel (125).

2. The semiconductor device of claim 1, further comprising:
an ohmic contact (515) disposed between the sidewall in the first direction of the second end portion of the channel (125) and the capacitor (550).

3. The semiconductor device of claim 2, wherein a cross-section of the ohmic contact (515) determined by a plane defined by the first direction and the vertical direction has a pentagonal shape.

4. The semiconductor device of claim 1, further comprising:
an ohmic contact (515) including a first portion (515a) and a second portion (515b) sequentially stacked along the first direction between the sidewall in the first direction of the second end portion of the channel (125) and the capacitor (550),
wherein a cross-section of the first portion (515a) of the ohmic contact (515) determined by a plane defined by the first direction and the vertical direction has a pentagonal shape.

5. The semiconductor device of claim 4,
wherein the first portion (515a) of the ohmic contact has a first width in the vertical direction, the second portion (515b) of the ohmic contact has a second width in the vertical direction, and the second width is greater than the first width.

6. The semiconductor device of claim 1, further comprising:
a source/drain layer (SDL2) and an ohmic contact (515) sequentially stacked along the first direction between the sidewall in the first direction of the second end portion of the channel (125) and the capacitor (550).

7. The semiconductor device of claim 6, wherein a cross-section of the source/drain layer (SDL2) determined by a plane defined by the first direction and the vertical direction has a pentagonal shape.

8. The semiconductor device of claim 6 or claim 7,
wherein the ohmic contact (515) includes a first portion (515a) and a second portion (515b) sequentially stacked along the first direction between a sidewall in the first direction of the source/drain layer (SDL2) and the capacitor (550), and
wherein the first portion (515a) of the ohmic contact (515) has a first width in the vertical direction, the second portion (515b) of the ohmic contact (515) has a second width in the vertical direction, and the second width is greater than the first width.

9. A semiconductor device comprising:
a channel (125) disposed on a substrate and extending in a first direction substantially parallel to an upper surface of the substrate;
a gate structure extending in a second direction substantially parallel to the upper surface of the substrate and crossing the first direction, wherein the gate structure surrounds at least a portion of a first end portion in the first direction of the channel (125);
a bit line (440) electrically connected to the channel (125) and extending in a vertical direction substantially perpendicular to the upper surface of the substrate along a sidewall in the first direction of the first end portion of the channel (125); and
a capacitor (550) disposed at a sidewall in the first direction of a second end portion in the first direction of the channel (125),
wherein a first thickness in the vertical direction of the second end portion of the channel (125) remains constant along the first direction and then gradually decreases when approaching the capacitor (550).

10. The semiconductor device of claim 9,
wherein the sidewall in the first direction of the second end portion of the channel (125) includes an upper sidewall and a lower sidewall, and
wherein in a cross-section of the channel (125) determined by a plane defined by the first direction and the vertical direction, the upper sidewall and the lower sidewall converge to form a V-shaped configuration, with a vertex formed by the upper sidewall and the lower sidewall being oriented toward an exterior of the channel (125).

11. The semiconductor device of claim 9 or claim 10, further comprising:
an ohmic contact (515) disposed between the sidewall in the first direction of the second end portion of the channel (125) and the capacitor (550).

12. The semiconductor device of claim 11, wherein a cross-section of the ohmic contact (515) determined by a plane defined by the first direction and the vertical direction has a concave pentagonal shape with sides facing the channel (125) concavely arranged.

13. The semiconductor device of claim 9, further comprising:
an ohmic contact (515) including a first portion and a second portion sequentially stacked along the first direction between the sidewall in the first direction of the second end portion of the channel (125) and the capacitor (550),
wherein a cross-section of the first portion of the ohmic contact (515) determined by a plane defined by the first direction and the vertical direction has a concave pentagonal shape with sides facing the channel (125) concavely arranged, and
wherein the first portion of the ohmic contact (515) has a first width in the vertical direction, the second portion of the ohmic contact (515) has a second width in the vertical direction, and the second width is greater than the first width.

14. The semiconductor device of claim 9, further comprising:
a source/drain layer (SDL2) and an ohmic contact (515) sequentially stacked along the first direction between the sidewall in the first direction of the second end portion of the channel (125) and the capacitor (550).

15. The semiconductor device of claim 14, wherein a cross-section of the source/drain layer (SDL2) determined by a plane defined by the first direction and the vertical direction has a concave pentagonal shape with sides facing the channel (125) concavely arranged.
